Europäisches Patentamt

European Patent Office

Office européen des brevets

(11) Numéro de publication : **0 329 533 B1**

# FASCICULE DE BREVET EUROPEEN

(45) Date de publication du fascicule du brevet :
**14.06.95 Bulletin 95/24**

(51) Int. Cl.⁶ : **H03M 7/40**

(21) Numéro de dépôt : **89400369.8**

(22) Date de dépôt : **09.02.89**

(54) **Procédé de codage et procédé de décodage à longueur variable, dispositif de codage et dispositif de décodage pour la mise en oeuvre de ce procédé.**

(30) Priorité : **17.02.88 FR 8801860**

(43) Date de publication de la demande :
**23.08.89 Bulletin 89/34**

(45) Mention de la délivrance du brevet :
**14.06.95 Bulletin 95/24**

(84) Etats contractants désignés :
**AT CH DE ES GB IT LI NL SE**

(56) Documents cités :
IBM TECHNICAL DISCLOSURE BULLETIN,
vol. 16, no. 2, juillet 1973, pages 487-488,New
York, US; D.C. VAN VOORHIS: "Construction
of codes with bounded code-word lengths"
IBM TECHNICAL DISCLOSURE BULLETIN,
vol. 24, no. 3, août 1981, pages 1514-1515,New
York, US; I. JONES: "Variable-length code-
word encoder/decoder"
Computer Design, vol. 16. no.4, avril 1977,
pages 85-90

(73) Titulaire : **THOMSON-CSF**
**173, Boulevard Haussmann**
**F-75008 Paris (FR)**

(72) Inventeur : **Perron, Claude Thomson-CSF**
**SCPI-51, Esplanade du Général de Gaulle**
**Cédex 67**
**F-92045 Paris la Défense (FR)**
Inventeur : **Tourtier, Philippe Thomson-CSF**
**SCPI-51, Esplanade du Général de Gaulle**
**Cédex 67**
**F-92045 Paris la Défense (FR)**

(74) Mandataire : **Ruellan-Lemonnier, Brigitte et al**
**THOMSON CONSUMER ELECTRONICS**
**9 Place des Vosges**
**La Défense 10**
**F-92400 Courbevoie (FR)**

## Description

L'invention concerne un procédé de codage et un procédé de décodage à longueur variable, ainsi qu'un dispositif de codage et un dispositif de décodage pour la mise en oeuvre de ce procédé.

Un signal numérisé est constitué d'échantillons qui peuvent prendre un nombre fini de valeurs. Ces valeurs sont des événements ayant chacun une certaine probabilité qui est en général différente pour chaque valeur. Il est connu de coder des événements ayant des probabilités inégales, par des mots de code prédéterminés ayant une longueur variable, en représentant les événements les plus fréquents statistiquement au moyen de mots de code de faible longueur et en représentant les événements les moins fréquents statistiquement au moyen de mots de code plus longs. Ce type de codage est connu sous le nom de codage entropique. Les mots de code sont des mots binaires qui sont transmis sous forme série sans discontinuité. Pour pouvoir décoder ces mots de code, il est nécessaire de pouvoir les distinguer les uns des autres malgré leur longueur variable.

La correspondance entre les mots de code et les événements peut être représentée graphiquement par une figure que l'on appelle un arbre de codage. Cet arbre de codage comporte une racine et des branches ramifiées constituées de segments. Chaque segment est associé à une valeur binaire 0 ou 1. L'arbre de codage permet d'associer un mot binaire à un événement, en fonction de sa probabilité, en parcourant l'arbre depuis sa racine jusqu'à l'extrémité d'une branche, cette extrémité étant associée à un événement. Le mot de code correspondant à un événement est constitué par la suite des bits associés aux différents segments qui sont parcourus pour aller de la racine jusqu'à l'extrémité de la branche considérée.

Réciproquement un événement peut être retrouvé au moyen du même arbre, en partant de la racine et en suivant un premier segment correspondant à la valeur du premier bit du mot de code, puis un second segment correspondant à la valeur du second bit du mot de code, etc... jusqu'à arriver à une extrémité de branche, cette extrémité correspond à un événement qui est l'événement à décoder.

Il est connu de réaliser un dispositif de codage et un dispositif de décodage mettant en oeuvre ce type de code à longueur variable, au moyen d'une mémoire morte pour le codage et d'une mémoire morte pour le décodage. La mémoire de codage contient des mots de code à des adresses constituées par les valeurs à coder. La mémoire de décodage contient les événements à des adresses constituées par les mots de code.

Une application du codage de Huffmann consiste, par exemple, à coder des coefficients résultant du codage d'une image par la transformation cosinus. Les coefficients ont des valeurs représentées sur 12 bits, par exemple. La mémoire morte de codage comporte alors une entrée d'adresse de 12 bits et une sortie de données de 16 bits, si le code a une longueur maximale fixée à 16 bits soit une capacité de 4 kilo-mots de 16 bits. La mémoire morte de décodage comporte alors une entrée d'adresse de 16 bits et une sortie de données de 12 bits, soit une capacité de 64 kilo-mots de 12 bits. La capacité des mémoires mortes nécessaires est donc relativement importante et conduit à un coût de réalisation important. D'autre part, la dynamique des valeurs à coder est limitée par cette capacité.

Le choix des mots de code consiste à réaliser une étude statistique des valeurs de coefficients de transformations d'une suite d'images typiques ; puis à déterminer des mots de code optimaux en appliquant un algorithme qui est décrit notamment dans la demande de brevet français FR-A- 2 600 226 déposée par la Demanderesse.

Cet algorithme permet d'obtenir un code de Huffmann optimal, pour des événements ayant des caractéristiques bien déterminées, mais il existe un grand nombre d'autres arbres de codage permettant de coder avec un coût non optimal une même suite d'événements.

Le dispositif utilisé pour réaliser un tel codage de Huffmann optimisé est une mémoire morte car il n'y a pas de relation mathématique simple entre les mots binaires représentant les événements à l'entrée du dispositif de codage et les mots binaires de code, à la sortie du dispositif de codage. Pour la même raison, le dispositif de décodage est constitué d'une mémoire morte. Ce type de dispositif a pour inconvénient de nécessiter en général une mémoire de capacité importante.

Un arbre de codage de Huffmann ne peut être optimisé que pour une répartition statistique bien déterminée. Si les probabilités des événements varient au cours du temps, il est envisageable d'utiliser un jeu d'arbres de codage distincts, en prévoyant un jeu de mémoires mortes dans le dispositif de codage et un jeu de mémoires mortes dans le dispositif de décodage. Cette solution a cependant pour inconvénient de multiplier la capacité des mémoires mortes utilisées. Cette solution est donc coûteuse en matériel.

Les deux documents suivants : "IBM Technical Disclosure Bulletin, vol. 24, n°3, août 1981, pages 1514-1515 ; "Variable length code-word encoder/decoder" par I. JONES et "Computer Design", vol. 16, n°4, avril 1977, pages 85-90 ; "Data compaction in computer system" par Y. DISHON divulguent des codes de HUFFMAN présentant une structure en arbre particulière, en ce qui concerne la répartition des "1" et des "0", fonction de leur longueur. Le codage est obtenu par utilisation d'une ou plusieurs tables.

Le but de l'invention est de proposer un procédé de codage et un procédé de décodage ne nécessitant pas l'utilisation de mémoires mortes, tout en permettant un changement d'arbre de codage en fonction des changements de répartition statistique des événements. L'objet de l'invention est un procédé de codage et un procédé de décodage dans lesquels les mots de code de Huffmann et les événements sont reliés par une loi arithmétique et logique simple dont les paramètres peuvent être modifiés facilement lorsque les caractéristiques statistiques des événements changent. Le dispositif de codage et le dispositif de décodage sont constitués essentiellement d'un dispositif arithmétique et logique, simple à réaliser, peu coûteux, et qui ne limite pas la dynamique de la variable à coder.

Selon l'invention, un procédé de codage à longueur variable, pour coder une suite de valeurs entières consécutives, positives ou nulles, dont la probabilité d'apparition décroit en fonction de la valeur, consistant pour coder chaque valeur E, à :

- déterminer un premier mot binaire comportant un nombre de bits B ayant une même valeur, B étant égal à la somme de $n(i)$ pour $i = 1$ à $i_0$-1, où $n(i)$ est un nombre entier fonction d'une variable entière $i$, et $i_0$ est un nombre entier fonction de E et tel que E est strictement supérieure à la somme de $(2^{n(i)}-1)$ pour $i = 1$ à $i_0$-1, et inférieure ou égale à la somme de $(2^{n(i)}-1)$ pour $i = 1$ à $i_0$;
- déterminer un second mot binaire ayant une valeur égale à la différence entre E et la somme de $(2^{n(i)}-1)$ pour $i = 1$ à $i_0$ -1 et un nombre de bit B′ égal à $n(i_0)$ ;
- constituer un mot de code réunissant le premier et le second mot binaire ainsi déterminés, le procédé est caractérisé en ce que $n(1)$ prend la valeur a

et $n(i)$ prend la valeur $n(i-1)$ si $(i-1)$ (modulo b) est entre 1 et b-1 inclus ;

et $n(i)$ prend la valeur $n(i-1) + c$ si $(i-1)$ (modulo b) = 0 ; a,b,c étant des constantes entières fixées.

Deux variantes du procédé selon l'invention permettent de coder aussi une suite finie de valeurs entières relatives et consécutives.

L'invention sera mieux comprise et d'autres détails apparaîtront à l'aide de la description ci-dessous et des figures l'accompagnant :

- les figures 1 à 3 représentent trois exemples d'arbres de codage de Huffmann utilisés pour la mise en oeuvre du procédé selon l'invention ;
- les figures 4 à 6 illustrent le procédé de décodage selon l'invention, pour ces trois exemples d'arbres de codage ;
- la figure 7 représente des arbres de codage correspondant à des valeurs entières relatives ;
- la figure 8 représente le schéma synoptique d'un exemple de réalisation du dispositif de codage selon l'invention, pour un seul arbre de codage ;
- la figure 9 représente le schéma synoptique d'un second exemple de réalisation du dispositif de codage selon l'invention, pour plusieurs arbres de codage ;
- la figure 10 représente le schéma synoptique d'un premier exemple de réalisation du dispositif de décodage selon l'invention, pour un ou plusieurs arbres de codage.

Le procédé selon l'invention peut être mis en oeuvre pour coder puis décoder toute sorte d'événements, pourvu que la distribution de probabilité soit monotone décroissante de part et d'autre de la moyenne de la variable aléatoire à coder. Dans ce cas, les événements peuvent être représentés facilement par une suite de valeurs entières consécutives positives ou nulles. Dans un premier temps, la description ci-dessous fera abstraction des valeurs à coder en les considérant comme une suite finie d'événements dans laquelle chaque événement à coder est représenté par un numéro croissant lorsque la probabilité de l'événement décroît. L'événement le plus probable est appelé événement n° 0, les autres étant appelés : événement n° 1, n° 2, etc... Dans le cas particulier où les valeurs à coder sont toutes positives ou nulles. Il y a alors identité entre le numéro de l'événement à coder et la valeur qui constitue l'événement à coder. Par exemple, si les valeurs à coder sont les valeurs entières 0, 1, 2, ..., 127 ; puisque ces valeurs ont des probabilités décroissantes, le procédé de codage est appliqué directement sur la suite des valeurs binaires : 0, 1, 2, ..., 127.

Les particularités du procédé selon l'invention apparaissent en considérant les arbres de codage obtenus par ce procédé. Chacun de ces arbres de codage comporte N niveaux, chaque $i^{ème}$ niveau pour $i = 1$ à N-1, comportant un nombre d'extrémités de branche, c'est à un nombre d'événements, fixé par une loi arithmétique, en fonction de $i$. Le $N^{ième}$ et dernier niveau comporte un nombre d'événement inférieur ou égal à celui fixé par cette loi.

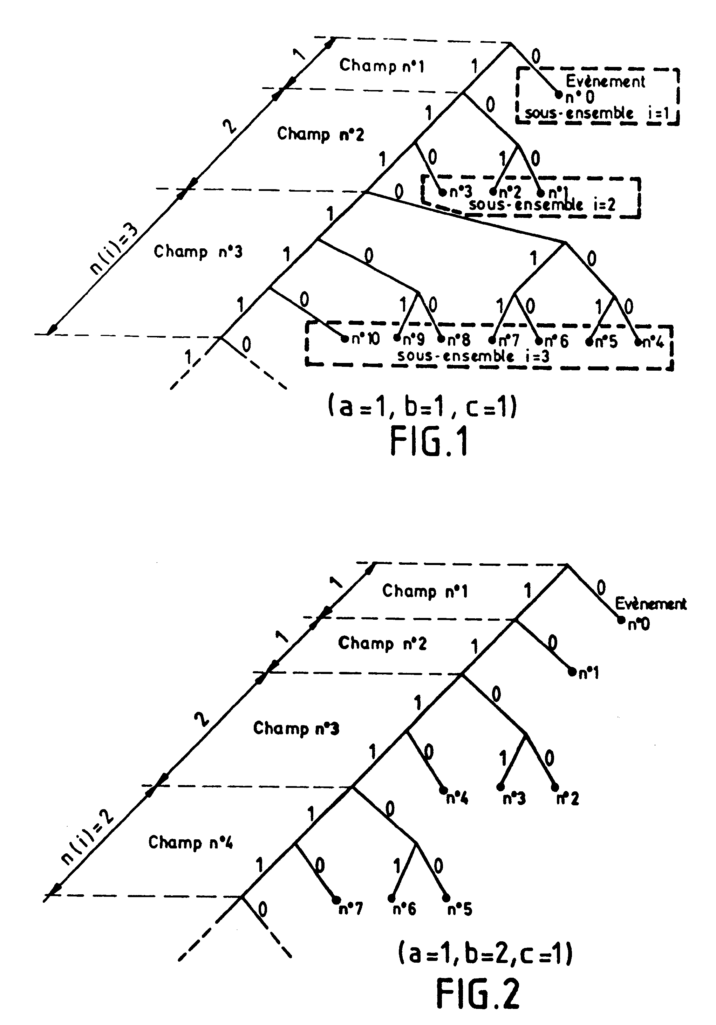

La figure 1 représente un exemple d'arbre de codage, dans lequel la racine de l'arbre est située en haut de la figure, et les segments correspondant à la valeur 1 sont orientés vers la gauche alors que les segments correspondant à la valeur 0 sont orientés vers la droite. Cet arbre comporte donc une branche constituée uniquement de segments correspondant à la valeur 1 et qui est la branche la plus à gauche sur cette figure. Entre deux segments consécutifs sur cette branche, il y a une bifurcation sur laquelle est raccordé un segment correspondant à la valeur 0. Ce segment peut avoir une extrémité libre et qui correspond alors à un événement qui est représenté par un point noir et par son numéro ; ou bien ce segment se termine par une bifurcation vers un segment correspondant à la valeur 1 et un segment correspondant à la valeur 0. Sur cette figure 1, le premier cas correspond à l'événement n° 3 et le second cas correspond aux événements n° 1 et 2, par exemple.

Pour construire un arbre ayant une structure régulière facile à définir par une loi de progression simple, l'ensemble des événements possibles est découpé en une suite de N sous-ensembles disjoints comportant chacun un nombre d'événements déterminé par une loi simple. Dans cet exemple, un premier sous-ensemble comporte seulement l'événement n° 0 ; un second sous-ensemble comporte les événements n° 1, n° 2, n° 3 ; un troisième sous-ensemble comporte les événements n° 4 à n° 10 ; etc... Chacun de ces sous-ensembles comporte $2^{n(i)}-1$ événements, $n(i)$ étant un nombre entier qui est fonction du rang $i$ du sous-ensemble d'événements, par une loi de progression prédéterminée. Il est à remarquer que le nombre de bits nécessaire pour constituer chacun des mots de code représentant les événements du sous-ensemble d'événements de rang $i_o$ dans l'arbre de codage, est égal à la somme de tous les nombres $n(i)$ pour $i = 1$ à $i_o$.

Sur la figure 1, un sous-ensemble de rang $i=1$ comporte l'événement n° 0 qui est codé par un bit prenant la valeur 0 ; un sous-ensemble de rang $i=2$ comporte les événements n° 1 à n° 3 codés par trois bits prenant respectivement les valeurs 100, 101, 110 ; un sous-ensemble de rang $i=3$ comporte les événements n° 4 à n° 10 qui sont codés par six bits prenant les valeurs : 111000, ..., 111110 ; etc... Comme cela apparaît sur cette figure, chaque événement du troisième sous-ensemble est représenté par un mot de code ayant 6 bits et qui est constitué d'une première partie, ayant 3 bits, commune à tous les événements du même sous-ensemble et d'une seconde partie, ayant 3 bits, dont la valeur correspond au rang d'un événement à l'intérieur du sous-ensemble considéré, en prenant pour convention que le premier événement a un rang de valeur 0. Par exemple, tous les événements, n° 4 à n° 10, du troisième sous-ensemble sont codés par un mot de code comportant comme première partie : 111. L'événement n° 4 est représenté par un mot de code dont la seconde partie est 000. L'événement n° 5 est représenté par un mot de code dont la seconde partie est 001. L'événement n° 6 est représenté par un mot de code dont la seconde partie est 010.

En règle générale, la première partie des mots de code du sous-ensemble de rang $i_o$ est formé de B bits ayant tous la valeur 1 et dont le nombre B est égal à la somme de tous les nombres $n(i)$ pour $i=1$ à $i_o-1$. Dans le cas particulier du premier sous-ensemble, $i_o=1$, la première partie ne comporte aucun bit.

En règle générale, la valeur de la seconde partie du mot de code varie de 0 à $2^{n(i_o)}-2$. Par exemple, pour le troisième sous-ensemble, sur la figure 1, la valeur de la seconde partie varie de 000 à 110.

Le fait d'avoir découpé l'ensemble des événements en une suite de sous-ensembles disjoints, chaque $i^{ème}$ sous-ensemble comportant $2^{n(i)}-1$ événements, permet d'utiliser toutes les valeurs possibles de la seconde partie du mot de code. Naturellement, si l'ensemble des événements comporte un nombre d'événements qui n'est pas égal à une puissance de 2, le dernier sous-ensemble, le $N^{ième}$ sous-ensemble, peut comporter un nombre d'événements inférieur à la valeur maximale de la seconde partie du mot de code correspondant à ce sous-ensemble.

La loi de progression de $n(i)$ en fonction de $i$ peut être quelconque, mais le codage et le décodage seront beaucoup plus simples à mettre en oeuvre, au moyen d'un simple dispositif de calcul arithmétique et logique, si cette loi peut être exprimée d'une manière simple par des opérations arithmétiques et logiques. Les lois de progression préférentielles sont des lois de forme linéaire, avec une valeur initiale a, et une pente égale à un nombre c d'événements pour un pas égal à b sous-ensembles. Autrement dit, $n(i)$ est donné par les formules suivantes :

$n(1) = a$

$n(i) = n(i-1)$ si $(i-1)$ (modulo b) est entre 1 et b-1 inclus;

et $n(i) = n(i-1) + c$ si $(i-1)$ (modulo b) $= 0$ ;

a, b, c étant des constantes entières fixées. Dans l'exemple de la figure 1 : a=1, b=1, c=1.

Une loi de progression $n(i)$ ayant été fixée, l'arbre de codage est défini. Pour coder une valeur E, appartenant à une suite de valeurs entières consécutives : 0, 1, 2, ..., M, le procédé selon l'invention consiste à :

déterminer la première partie du mot de code en calculant son nombre de bits, B, en fonction de E. Ce nombre de bits ne peut prendre qu'une des valeurs de la suite :

$n(1)$
$n(1) + n(2)$
$n(1) + n(2) + n(3)$
$n(1) + n(2) + n(4)$
etc...

Déterminer B, pour une valeur E donnée, consiste à déterminer le rang $i_o$ du sous-ensemble dans lequel est placé l'événement constitué par la valeur E.

Chaque $i_o$ème sous-ensemble comporte les événements constitués par les valeurs strictement supérieures à la somme de $2^{n(i)}-1$ pour $i=1$ à $i_o-1$ et inférieures ou égales à la somme de $2^{n(i)}-1$ pour $i=1$ à $i_o$. Le procédé consiste donc à déterminer $i_o$ en comparant E avec la somme de $(2^{n(i)}-1)$ pour $i$ croissant, jusqu'à ce que cette somme soit supérieure à E. Puis en déduire B qui est égal à la somme de $n(i)$ pour $i=1$ à $i_o-1$ ;

- déterminer la seconde partie du mot de code, en calculant le rang de la valeur E dans le $i_o$ème sous-ensemble. Si le premier événement du $i_o$ème sous-ensemble est supposé avoir le rang 0, alors le rang de la valeur E dans ce sous-ensemble est égal à E moins le nombre total de tous les événements placés dans les sous-ensembles de rang $i=1$ à $i=i_o-1$. Il est à noter que la seconde partie du mot de code comporte non seulement des bits significatifs nécessaires pour exprimer ce rang, mais comporte en outre des bits non significatifs, de valeur nulle, en nombre tel que le nombre total $B'$ de bits de la seconde partie du mot de code est égale à $n(i_o)$. Par exemple, sur la figure 1, l'événement n° 7 a un rang égal à 4, en comptant à partir de 0, dans le 3ème sous-ensemble d'événements, donc $B'=n(3)=3$ bits et la valeur de la seconde partie du mot de code est égale à 4, donc cette seconde partie est constituée par 011.

La figure 2 représente un autre arbre de codage correspondant à une loi de progression $n(i)$ ayant pour paramètres : $a=1$, $b=2$, $c=1$. Dans cet arbre, les deux premiers sous-ensembles ne comportent qu'un seul événement : respectivement n° 0 et n° 1. Les deux sous-ensembles suivants comportent chacun trois événements. Les deux sous-ensembles suivants, qui ne sont pas représentés, comportent chacun quatre événements. Cette loi de progression fait que l'événement du sous-ensemble de rang $i=1$ est représenté par un mot de code ayant $n(1)=1$ bit ; l'événement du sous-ensemble de rang $i=2$ est représenté par un mot de code ayant $n(1)+n(2)=2$ bits ; les événements du sous-ensemble de rang $i=3$ est représenté par un mot de code ayant $n(1)+n(2)+n(3)=4$ bits ; le sous-ensemble de rang $i=4$ est représenté par un mot de code ayant $n(4)+n(3)+n(2)+n(1) = 6$ bits ; etc...

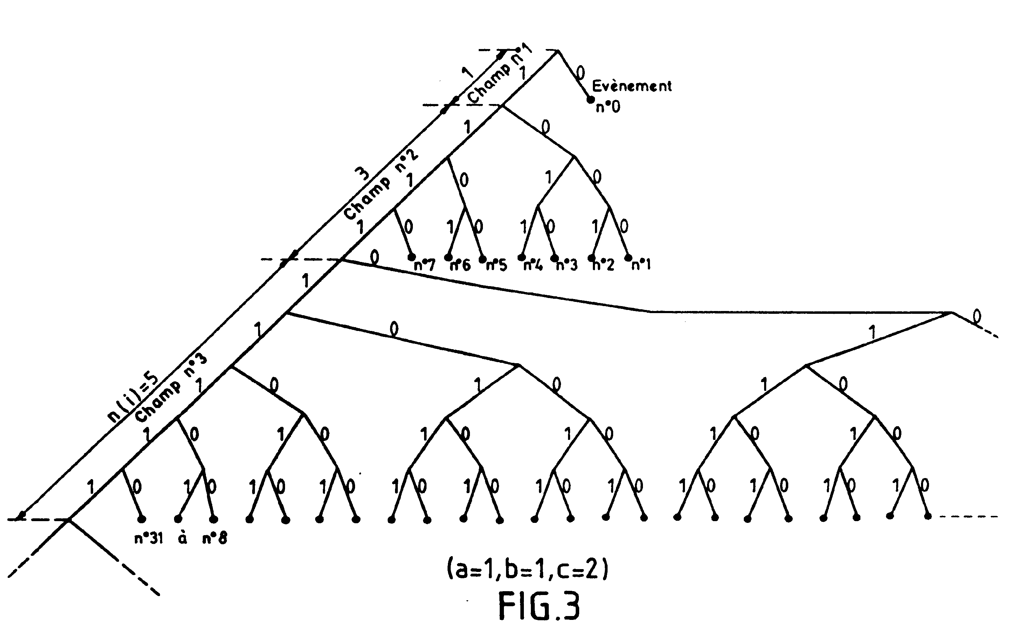

La figure 3 représente un troisième exemple d'arbre de codage, correspondant à une loi de progression ayant pour paramètres $a=1$, $b=1$, $c=2$. Il comporte un premier sous-ensemble comportant un seul événement, n° 0 ; un second sous-ensemble comportant sept événements, n° 1 à n° 7 ; un troisième sous-ensemble comportant 24 événements, n° 8 à n° 31 ; etc...

En règle générale la valeur de a est choisie de préférence entre 1 et 5 inclus, la valeur de b est choisie de préférence entre 1 et 3 inclus, et la valeur de c est choisie de préférence entre 0 et 3 inclus. Les diverses lois de progression ainsi obtenues ne fournissent pas des arbres de codage optimaux, mais il est possible de sélectionner parmi eux l'arbre donnant le coût de codage minimal pour une application donnée.

Un perfectionnement au procédé de codage selon l'invention concerne les applications telles que le codage d'images, où la répartition statistique des événements peut varier beaucoup au cours du temps. Il consiste à définir, pour un même nombre d'événements, plusieurs ensembles de mots de code, procurant un coût de codage particulièrement faible respectivement pour différentes répartitions statistiques des événements. La sélection de l'arbre de codage le meilleur à un moment donné est réalisée en calculant le coût de codage d'un certain nombre d'événements, pendant une certaine durée, en appliquant en parallèle les différents arbres de codage, puis en déterminant lequel procure le coût de codage le plus petit.

Naturellement il est nécessaire dans ce cas de transmettre une information accompagnant les données codées, pour indiquer lequel des arbres de codage prédéterminés a été utilisé. Ces informations supplémentaires peuvent être constituées par exemple de la valeur binaire, en clair, des paramètres a, b, c.

Le décodage est réalisé selon un arbre de décodage qui est identique à l'arbre de codage. Par exemple, soit à décoder la suite de bits suivante, ayant été codée par l'arbre de codage représenté sur la figure 1.

11110011101101001

Pour décoder le premier événement représenté par cette suite de données codées, il suffit de suivre sur l'arbre de la figure 1 les segments associés respectivement aux valeurs 1,1,1,0,0, etc, en partant de la racine. Ce chemin aboutit à l'événement n° 8. Le premier mot de code est donc 11100 et représente l'événement n° 8. Pour décoder le mot de code suivant il faut suivre de nouveau l'arbre en partant de la racine, pour les valeurs binaires 11101, etc.

Le décodage consiste en deux étapes : une première étape consiste à localiser dans quel sous-ensemble se trouve l'événement à décoder ; une seconde étape consiste à trouver le rang de l'événement à décoder, parmi tous les événements de ce sous-ensemble.

Dans l'exemple considéré sur la figure 1, la loi de progression : $a=1$, $b=1$, $c=1$, permet au dispositif de décodage de savoir que $n(1)=1$ et que les événements du sous-ensemble de rang $i=1$ sont donc codés par un seul bit, et donc qu'il n'y a qu'un seul événement dans ce sous-ensemble. Cette loi de progression permet aussi au dispositif de décodage de savoir que : les événements du sous-ensemble de rang $i=2$ sont représentés par un mot de code ayant $n(1)+n(2)=2$ bits, comportant une première partie de $n(1)=1$ bit de valeur toujours égale à 1, et une seconde partie comportant $n(2)=1$ bit pouvant prendre des valeurs diverses ; que les événements du sous-ensemble de rang $i=3$ sont codés par $n(1)+n(2)+n(3)=6$ bits, comportant une première partie de $n(1)+n(2)=3$ bits de valeur toujours égale à 111 et une seconde partie comportant $n(3)=3$ bits pouvant prendre des valeurs diverses ; etc...

Le décodage consiste donc à détecter tout d'abord si le premier groupe des bits de la suite de données codées est : 1, ou 111, ou 111111 ; etc..., en découpant, dans la suite des données codées, une suite de champs distincts ayant respectivement $n(1)$ bits, $n(2)$ bits, $n(3)$ bits, etc..., et tester la valeur des bits de ces champs pour i croissant, jusqu'à trouver un champ comportant au moins un bit de valeur 0. Pour cela, un exemple de mise en oeuvre du procédé consiste à calculer une suite de nombres entiers n(1), ..., n(i), pour i entier croissant à partir de 1, en fonction de la loi de progression prédéterminée ; déterminer la valeur CH(i) d'un champ constitué de n(1)+n(2)+...+n(i) bits consécutifs de la suite des données codées ; puis comparer la valeur CH(i) à la valeur $2^{n(i)}-1$ ; et déterminer une valeur $i_o$ de i, telle que CH($i_o$) est comprise entre $2^{n(i_o-1)}-1$ et $2^{n(i_o)}-1$. Ceci équivaut à rechercher la première bifurcation devant être effectuée en direction de la droite, sur l'arbre de la figure 1, lorsque cet arbre est parcouru depuis la racine jusqu'à l'événement à décoder.

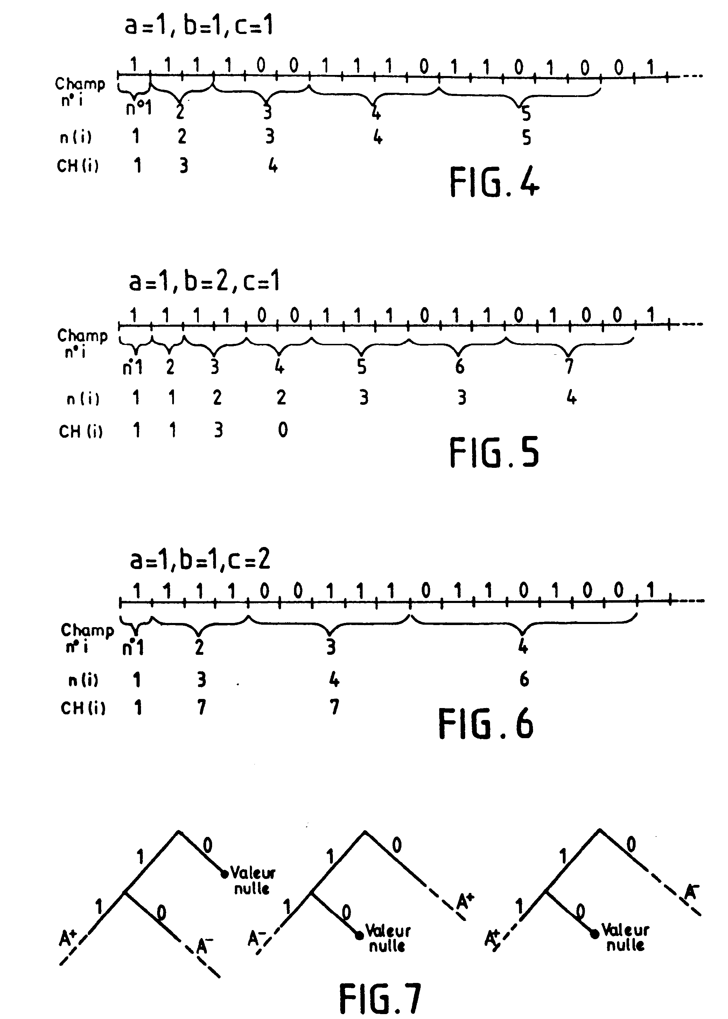

La figure 4 représente les champs n° i, pour i=1 à 5, qui sont découpés successivement dans la suite des données binaires 11110011101101001, ayant été codée selon l'arbre de la figure 1. La loi de progression n(i) est la même que celle utilisée pour le codage. Le nombre de bits de ces champs est calculé selon les formules suivantes :

n(1) = a

n(i) = n(i-1) si (i-1) (modulo b) est entre 1 et b-1 inclus ;

n(i) = n(i-1) + c si (i-1) (modulo b) = 0

a, b, c étant les même paramètres que ceux utilisés pour le codage. Dans cet exemple : a=1, b=1, c=1.

Les champs n° 1, n° 2, n° 3, n° 4, n° 5, ont donc respectivement pour nombre de bits : 1, 2, 3, 4, 5. Le champ n°1 et le champ n° 2 sont chacun constitués d'un mot binaire ayant une valeur de la forme $2^{n(i)}-1$, respectivement les valeurs 1 et 11. Par contre, le champ n° 3 est constitué de trois bits ayant la valeur binaire 100 qui n'est pas égal à $2^{n(3)}-1$ = 111, puisqu'il comporte deux bits égaux à 0. Dans cet exemple, $i_o$ est donc égal à 3 et n($i_o$) est égal à 3 ; la première partie du mot de code est donc constituée de 111 et la seconde partie de ce mot de code est constituée par les bits du champ n° 3, c'est-à-dire 100.

La valeur binaire de cette seconde partie correspond au rang de l'événement à décoder, à l'intérieur de son sous-ensemble d'événements. Le champ n° 3 ayant une valeur égale à 4, le rang de l'événement est donc le cinquième rang à l'intérieur du troisième sous-ensemble, compte tenu du fait que le premier événement d'un sous-ensemble correspond à la valeur 0 pour la seconde partie du mot de code. Pour connaître son numéro à l'intérieur de l'ensemble des événements à décoder il suffit d'additionner la valeur 4 au nombre total d'événements contenus dans le premier et le deuxième sous-ensemble. Comme cela a été mentionné précédemment, chaque sous-ensemble de rang i dans l'arbre de codage, à l'exception éventuellement du dernier sous-ensemble, comporte $2^{n(i)}-1$ événements. Par conséquent, le numéro de l'événement à décoder est égal à la somme de la valeur 4 plus le nombre d'événements dans le sous-ensemble n° 2, qui est égal à 3, plus le nombre d'événements dans le sous-ensemble n° 1, qui est égal à 1. Soit un total de 8, qui désigne bien l'événement n° 8.

Il est à remarquer que, pour additionner les nombres d'événements $2^{n(i)}-1$ pour i=1 à $i_o-1$, il suffit d'additionner les valeurs CH(i) pour i=1 à $i_o-1$, car CH(i) est la valeur d'un champ de n(i) bits de valeur 1. Comme il faut additionner en outre la valeur CH($i_o$) du champ de rang $i_o$ où a été détecté le premier bit de valeur 0, il suffit d'additionner toutes les valeurs CH(i) pour i=1 à $i_o$, pour obtenir le numéro de l'événement à décoder.

La figure 5 illustre le décodage de la même suite de données binaires dans le cas où elle résulte d'un codage par l'arbre de codage représenté sur la figure 2. La suite des valeurs n(i) correspondant à la loi de progression ayant les paramètres a=1, b=2, c=1, est : 1,1,2,2,3,3,4,4, etc... Les champs n° 1, n° 2, n° 3 sont donc constitués respectivement par : 1 bit, 1 bit, et 2 bits des données codées. Ces champs ne comportent que des 1, c'est-à-dire correspondent à des valeurs de la forme $2^{n(i)}-1$. Le champ n° 4, par contre, comporte deux 0, par conséquent la première partie du mot de code est constituée par 1111.

Il est possible de conclure aussi que $i_o$ est égal à 4 et n($i_o$) est égal à 2. La seconde partie du mot de code est constituée par les deux bits du champ n° 4 ; c'est-à-dire 00. L'événement à décoder est donc le premier événement dans le sous-ensemble n° 4. Le nombre d'événements dans le sous-ensemble n° 1 étant égal à 1, le nombre d'événements dans le sous-ensemble n° 2 étant égal à 2, et le nombre d'événements dans le sous-ensemble n° 3 étant égal à 3, le rang de l'événement à décoder est donc le rang n° 5 dans l'ensemble des événements, cet ensemble étant numéroté à partir du n° 0.

La figure 6 illustre le décodage de la même suite de données binaires dans le cas où elle résulte d'un codage selon l'arbre de codage représenté sur la figure 3, les paramètres de la loi de progression étant a=1, b=1, c=2. Le nombre n(i) des bits dans chaque champ considéré successivement est égal à : 1, 3, 4, 6 etc... La valeur CH(i) du champ n° 1 et du champ n° 2 est égale respectivement à 1 et à 7, c'est-à-dire est de la forme $2^{n(i)}-1$. Le champ n° 3 n'est pas de cette forme et a pour valeur binaire 00111, c'est-à-dire une valeur décimale égale à 7. L'événement à décoder est donc le huitième dans le troisième sous-ensemble d'événements et son numéro est égal à 15 dans l'ensemble des événements possibles.

Deux variantes de mise en oeuvre du procédé selon l'invention permettent le codage et le décodage de valeurs entières relatives et consécutives, dont la probabilité d'apparition décroît en fonction de la valeur absolue. Elles permettent le codage d'une variable aléatoire x non centrée sur sa valeur moyenne m, en codant l'écart à la moyenne : x-m. Dans un premier cas, les valeurs positives et les valeurs négatives sont supposées avoir la même probabilité, pour une valeur absolue donnée. Par exemple les valeurs entières positives 1, 2, 3, ..., 63 sont supposées avoir les mêmes probabilités que les valeurs entières négatives -1, -2, ..., -63 ; et leurs probabilités sont supposées inférieures à celle de la valeur nulle et décroissantes dans cet ordre. Le codage de ces valeurs consiste à leur faire correspondre préalablement un numéro d'événement conformément au tableau suivant :

| valeur | événement |
|---|---|
| 0 | n° 0 |
| 1 | 1 |
| -1 | 2 |
| 2 | 3 |
| -2 | 4 |
| . | . |
| . | . |
| . | . |
| 63 | 126 |
| -63 | 127 |

La mise en correspondance des valeurs : -63, ..., 0, ...63, avec les numéros d'événements : 0 à 127, est réalisée d'une manière très simple, sans nécessiter une table de transcodage stockée en mémoire. En effet, il suffit de représenter chaque valeur relative par un bit de signe et par des bits de valeur absolue, puis de placer le bit de signe à droite du bit de plus faible poids.

Par exemple la valeur -2, est représentée par un bit de signe ayant la valeur 1 (signe -) et deux bits de valeur 10 (valeur absolue). Elle devient 101, c'est-à-dire 8.

Le codage est ensuite réalisé comme décrit précédemment dans le cas d'une suite de valeurs entières positives 0, 1, ..., 127 ayant des probabilités décroissantes.

Dans un second cas, les valeurs négatives sont supposées avoir des probabilités non identiques à celles des valeurs positives, pour une même valeur absolue. Le procédé consiste alors à utiliser un arbre de codage comportant trois sous-arbres correspondant respectivement aux valeurs positives, aux valeurs négatives, et à la valeur nulle. La valeur nulle correspond à un sous-arbre très court constitué d'un tel segment, ou de deux segments.

En général, la probabilité des valeurs positives ou négatives décroît de manière monotone en fonction de la valeur absolue, ce qui permet d'établir facilement une correspondance entre les valeurs à coder et les numéros d'événement qui sont utilisés dans les sous-arbres de codage. Par exemple, soit à coder les valeurs entières relatives : -63, ..., 0, ..., +63. Un premier sous-arbre, A⁻, défini par un premier jeu de paramètres (a, b, c) est établi pour des événements n° 0 à n° 62 avec les correspondances suivantes :

| valeur | événement |
|---|---|
| -1 | n° 0 |
| -2 | |
| . | |
| . | |
| . | |
| -63 | n° 62 |

Le codage selon cet arbre est réalisé comme décrit précédemment pour des entiers positifs, mais il y a un décalage systématique d'une unité entre la valeur absolue et le numéro d'événement. Ce décalage peut être réalisé simplement au moyen d'un additionneur. Un second sous-arbre, A⁻, défini un second jeu de paramètres (a, b, c) est établi pour des événements numéros n° 0', à n° 62' avec les correspondances suivantes :

| valeur | événement |
|---|---|
| +1 | n° 0' |
| +2 | . |
| . | . |
| . | . |
| . | . |
| +63 | n° 62' |

Le codage selon cet arbre est réalisé comme décrit précédemment pour des entiers positifs, mais il y a un décalage systématique d'une unité entre la valeur et le numéro d'événement. Ce décalage peut être réalisé simplement au moyen d'un additionneur.

Finalement, chaque valeur entière relative est codée par un mot de code comportant un préfixe de deux bits suivi d'un mot de code ayant une longueur variable. Le préfixe permet de sélectionner soit la valeur nulle, soit le premier sous-arbre, A⁻, soit le second sous-arbre A⁺. La valeur des 2 bits du préfixe est choisie en fonction des probabilités d'apparition d'une valeur nulle, d'une valeur positive, d'une valeur négative respectivement. La figure 7 représente l'arbre résultant dans les trois cas possibles.

Le décodage selon un tel arbre consiste tout d'abord à lire le préfixe, qui est constitué par les deux premiers bits de données codées, pour savoir si ces données codées représentent une valeur nulle, une valeur positive, ou une valeur négative. Dans le premier cas, la conclusion est rapide. Dans le second et le troisième cas, il faut appliquer le procédé de décodage décrit précédemment, en utilisant respectivement le premier ou le second jeu de paramètres ; puis il faut ajouter une unité au numéro de l'événement trouvé, afin de retrouver la valeur absolue exacte, et enfin, il faut adjoindre à cette valeur absolue un bit de signe, déduit de la valeur du préfixe.

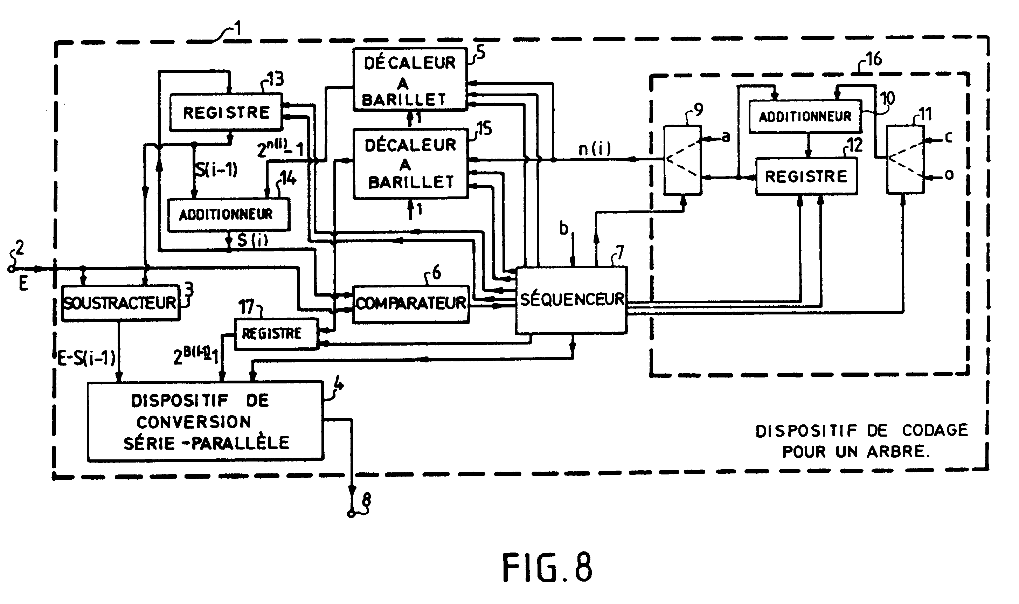

La figure 8 représente le schéma synoptique d'un exemple de réalisation d'un dispositif de codage 1 pour la mise en oeuvre du procédé selon l'invention lorsqu'un seul arbre de codage est utilisé. Cet exemple comporte : une borne d'entrée 2, recevant une suite de mots binaires représentant des valeurs entières positives à coder ; un soustracteur 3 ; un dispositif de conversion série-parallèle 4 ; deux décaleurs à barillet 5 et 15 ; un comparateur 6 ; un séquenceur 7 ; une borne de sortie 8 fournissant une suite de mots de code sous la forme série ; deux registres 13 et 17 ; un additionneur 14 ; et des moyens de calcul 16 pour calculer une suite de valeurs entières n(i) selon une loi de progression déterminée.

Ces moyens 16 comportent : deux multiplexeurs à deux entrées et une sortie, 9 et 11 ; un additionneur 10 ; et un registre 12. Les moyens 16 calculent une suite de valeurs n(i) pour i croissant à partir de 1, selon une loi de progression prédéterminée définie par des constantes, a, b, c. Le rythme de calcul de cette suite est fixé par le séquenceur 7 qui commande les multiplexeurs 9 et 11 et qui commande le registre 12. Il commande en outre les décaleurs 5 et 15, les registres 13 et 17, et le dispositif 4.

Le multiplexeur 11 reçoit la valeur 0 sur une première entrée et reçoit la valeur c sur une seconde entrée. Une sortie du multiplexeur 11 est reliée à une première entrée de l'additionneur 10 qui reçoit sur une seconde entrée une valeur fournie par une sortie du registre 12. La sortie de l'additionneur 10 est reliée à une entrée du registre 12. Une première entrée du multiplexeur 9 est reliée à une sortie du registre 12. Une seconde entrée du multiplexeur 9 reçoit la valeur constante a. Une sortie du multiplexeur 9 constitue la sortie des moyens de calcul 16 et fournit une suite de valeurs n(i) à une entrée de commande du décaleur 5. Une entrée d'horloge et une entrée de remise à zéro du registre 12 sont reliées respectivement à deux sorties du séquenceur 7. Une première entrée du séquenceur 7 reçoit la valeur de la constante b. Une seconde entrée du séquenceur 7 est reliée à une sortie du comparateur 6.

Au début du codage de chaque événement, le séquenceur 7 commande une remise à zéro du registre 12. L'additionneur 10 et le registre 12 constituent un accumulateur pour calculer chaque valeur n(i). Pour calculer la première valeur, n(1), le séquenceur 7 commande le multiplexeur 9 pour qu'il transmette à la sortie des moyens 16 la valeur a. Pour les valeurs n(i) avec i compris entre 2(modulo b) inclus et b(modulo b) inclus, le séquenceur 7 commande le multiplexeur 9 pour qu'il transmette la valeur fournie par la sortie du registre 12 et il commande le multiplexeur 11 pour qu'il transmette à l'additionneur 10 la valeur 0. La valeur n(i) reste donc constante pour une suite de b valeurs de i. Lorsque i, qui est compté par un compteur interne au séquenceur 7, est égal à (b+1)modulo b, le séquenceur 7 commande le multiplexeur 11 pour transmettre la valeur c à l'entrée de l'additionneur 10. Pour chaque valeur n(i), quel que soit i, le séquenceur 7 commande l'entrée d'horloge du registre 12 pour stocker une valeur n(i).

Dans cet exemple de réalisation les mots de code ont une longueur maximale de 16 bits. Le décaleur 5 possède : une première entrée de commande reliée à la sortie des moyens de calcul 16 ; une entrée de données recevant en permanence une valeur 1 ; et une sortie reliée à une première entrée de l'additionneur 14. Le décaleur 5 possède en outre deux entrées de commande reliées à deux sorties du séquenceur 7 pour commander une remise à zéro du décaleur 5 pour chaque nouvelle valeur de n(i), puis pour commander la sortie en parallèle de n(i) bits de poids faible ayant la valeur 1 et de 16-n(i) bits de poids fort ayant la valeur 0.

Le décaleur 15 possède une première entrée de commande reliée à la sortie des moyens de calcul 16 ; une entrée de données recevant en permanence la valeur 1 ; et une sortie reliée à une entrée du registre 17. Le décaleur 15 possède en outre deux entrées de commande reliées à deux sorties du séquenceur 7 pour commander une remise à zéro du décaleur 15 au début du codage de chaque valeur à coder, puis pour commander la sortie en parallèle de B(i-1) bits de poids faible, ayant la valeur 1 et de 16-B(i-1) bits de poids fort ayant la valeur 0, B(i-1) étant la somme n(1)+n(2)+...+n(i-1). Pour chaque nouvelle valeur n(1), n(2), ..., n(i-1) le séquenceur 7 fournit des impulsions d'horloge et un signal de validation au décaleur 15 pour que sa sortie fournisse respectivement n(1), n(2), ... n(i-1) bits supplémentaires ayant la valeur 1.

Une entrée de commande du registre 17 est reliée à une sortie du séquenceur 7. Une sortie du registre 17 est reliée à une entrée du dispositif 4.

Une seconde entrée de l'additionneur 14 est reliée à une sortie du registre 13. Une sortie de l'additionneur 14 est reliée à une entrée du registre 13 et à une première entrée du comparateur 6. La sortie du registre 13 est reliée en outre à une première entrée du soustracteur 3. Une seconde entrée du soustracteur 3 est reliée à la borne d'entrée 2. Une sortie du soustracteur 3 est reliée à une seconde entrée du dispositif 4. Une entrée de commande et une sortie du dispositif 4 sont reliées respectivement à une sortie du séquenceur 7 et à la borne de sortie 8 du dispositif de codage 1. Une entrée d'horloge et une entrée de remise à zéro du registre 13 sont reliées respectivement à deux sorties du séquenceur 7. Une seconde entrée du comparateur 6 est reliée à la borne d'entrée 2. La sortie du comparateur 6 est reliée à une entrée du séquenceur 7.

Une suite de valeurs entières positives ou nulles est appliquée à la borne d'entrée 2 sous la forme de mots binaires de 8 bits, pour être codée. La probabilité d'apparition de chaque valeur est supposée décroissante quand la valeur augmente. A l'instant considéré, une valeur E est appliquée à la borne d'entrée 2. Le séquenceur 7 commande alors une remise à zéro du registre 13, puis commande le calcul d'une valeur $n(1)$ par les moyens de calcul 16. Le décaleur 5 fournit une valeur $2^{n(1)}-1$ à l'additionneur 14. La sortie du registre 13 fournit une valeur nulle. Donc la sortie de l'additionneur 14 fournit une valeur $S(1)=2^{n(1)}-1$, puis celle-ci est stockée dans le registre 13. La sortie du registre 13 fournit une valeur $S(1)$ qui est alors égale à $2^{n(1)}-1$. Le comparateur 6 compare les valeurs $S(1)$ et E. Si $S(1)$ est inférieure ou égale à E, le comparateur 6 fournit un signal logique au séquenceur 7 pour qu'il incrémente i d'une unité et commande le calcul d'une nouvelle valeur $n(i)$.

Le séquenceur 7 commande des moyens de calcul 16 pour fournir une suite de valeurs $n(i)$ croissantes selon la loi de progression déterminée par le jeu de paramètres a, b, c ; jusqu'à ce que le comparateur 6 détecte que la valeur $S(i)$ fournie par l'additionneur 14 est supérieure à la valeur E à coder. Le séquenceur 7 arrête alors d'incrémenter i. Le séquenceur 7 commande le stockage dans le registre 13 de la valeur $S(i)$ fournie par l'additionneur 14, chaque fois que la valeur i a été incrémentée, sauf si le comparateur 6 détecte que E est inférieur à la valeur fournie par l'additionneur 14. Dans ce cas, la valeur i a atteint $i_o$ ; l'additionneur 14 fournit $S(i_o)$ mais le registre 14 contient $S(i_o-1)$ ; et c'est cette dernière valeur qui est utilisée par le soustracteur 3 pour calculer la première partie du mot de code qui représente la valeur E.

Lorsque l'incrémentation de i est arrêtée à $i_o$, le décaleur 15 fournit un mot binaire ayant $B(i_o)$ bits de poids faible ayant la valeur 1, autrement dit ce mot a pour valeur $2^{B(i_o)}-1$. Le registre 17 contient le mot binaire ayant été déterminé précédemment par le décaleur 15, c'est-à-dire ayant pour valeur $2^{B(i_o-1)}-1$. En effet, le séquenceur 7 commande l'inscription, dans le registre 17, du mot binaire fourni par le décaleur 15 pour chaque nouvelle valeur de $n(i)$, jusqu'à ce que i ait atteint la valeur $i_o$. La dernière valeur stockée dans le registre 17 est donc $2^{B(i_o-1)}-1$.

Le dispositif 4 constitue alors le mot de code représentant l'événement à coder, ce mot de code comportant une première partie constituée par les bits de valeur 1 du mot binaire fourni par le registre 17, et une seconde partie constituée par la valeur binaire de la différence entre E et $S(i_o-1)$, calculée par le soustracteur 3. Le dispositif 4 fournit le mot de code sous la forme série à la borne de sortie 8.

Le séquenceur 7 réinitialise l'ensemble du codeur pour traiter ensuite l'événement suivant. Pour cela, il remet à zéro les registres 12 et 13, et il remet le multiplexeur 9 dans l'état où il transmet la valeur a ; et il remet à zéro son compteur interne qui compte la valeur de i.

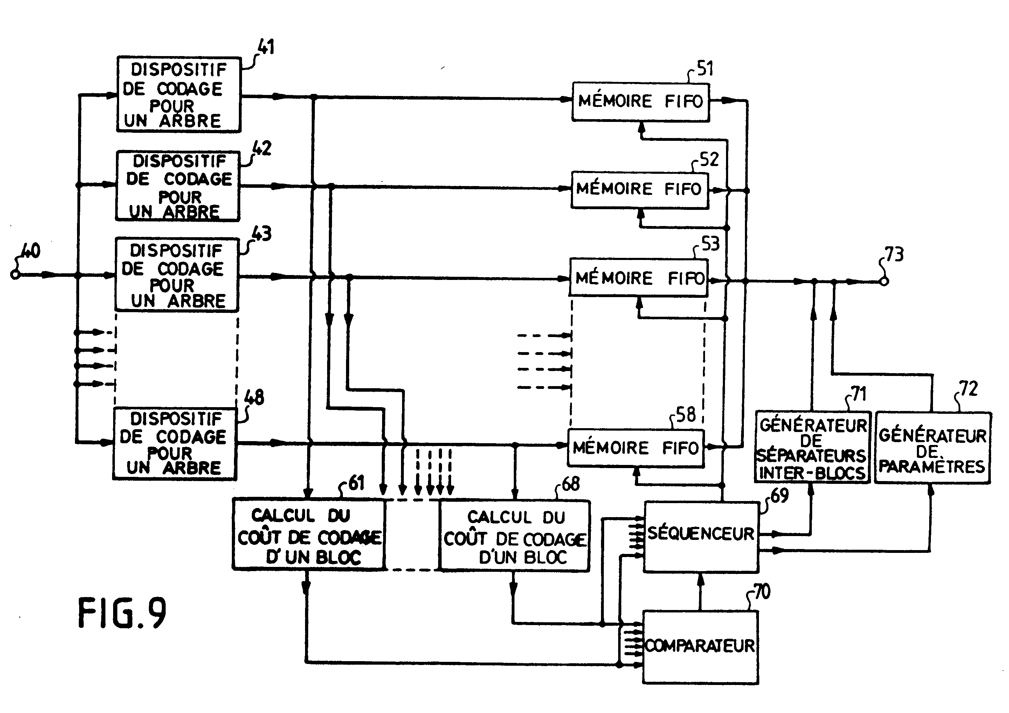

La figure 9 représente le schéma synoptique d'un exemple de réalisation d'un dispositif de codage selon l'invention permettant de coder des événements selon huit arbres disctincts, en sélectionnant finalement l'arbre de codage procurant un coût de codage minimal. Cet exemple comporte : huit codeurs, 41 à 48, identiques au dispositif de codage 1 décrit précédemment et représenté sur la figure 8, chacun de ces codeurs réalisant un codage correspondant à un arbre différent ; huit mémoires FIFO, 51 à 58 ; huit dispositifs de calcul du coût de codage d'un bloc, 61 à 68 ; un séquenceur 69 ; un comparateur 70 ; un générateur 71 de séparateurs inter-blocs ; un générateur de paramètres, 72 ; et une borne de sortie 73. Chaque mémoire FIFO 51 à 58 a une capacité correspondant aux mots de code d'un bloc de 16x16 valeurs.

Les entrées des codeurs 41 à 48 sont reliées toutes à la borne d'entrée 40 recevant une suite de valeurs entières positives qui sont à coder. Les sorties des codeurs 41 à 48 sont reliées respectivement à des entrées de données des mémoires FIFO 51 à 58 et à des entrées des dispositifs 61 à 68 de calcul du coût de codage d'un bloc. Ces dispositifs 61 à 68 ont des sorties reliées respectivement à des entrées du comparateur 70 et du séquenceur 69. Le séquenceur 69 a des sorties reliées à des entrées de commande des mémoires 51 à 58 pour commander l'écriture et la lecture dans ces mémoires. Une sortie du comparateur 70 est reliée à une entrée du séquenceur 69. Deux sorties du séquenceur 69 sont reliées respectivement à des entrées de commande du générateur 71 et du générateur 72. Des sorties des mémoires 51 à 58 et des générateurs 71 et 72 sont reliées en parallèle à la borne de sortie 73.

Les valeurs à coder sont traitées par bloc de 16x16 valeurs, un arbre de codage étant sélectionné parmi 8, sur le critère d'un coût de codage minimal. Les codeurs 41 à 48 déterminent en parallèle un mot de code pour chaque événement ; ces mots de code sont inscrits en parallèle dans les mémoires FIFO 51 à 58, sous la commande du séquenceur 69 ; et les dispositifs de calcul 61 à 68 déterminent en parallèle le coût de codage d'un bloc. A la fin du calcul du coût de codage d'un bloc, le comparateur 70 fournit au séquenceur 69 un mot binaire désignant le codeur ayant fourni un coût de codage minimal.

Le séquenceur 69 commande le générateur 71 pour transmettre un séparateur inter-blocs qui est un mot binaire inimitable par toute concaténation licite des mots de code fournis par l'un des huit arbres de codage. Puis le séquenceur 69 commande le générateur 72 pour qu'il transmette en clair la valeur des paramètres a, b, c correspondant à l'arbre de codage ayant procuré le coût de codage minimal. Enfin, le séquenceur 69 commande la lecture des mots de code correspondant à l'ensemble du bloc de valeurs à coder, dans une seule mémoire 51 à 58 correspondant au coût de codage minimal.

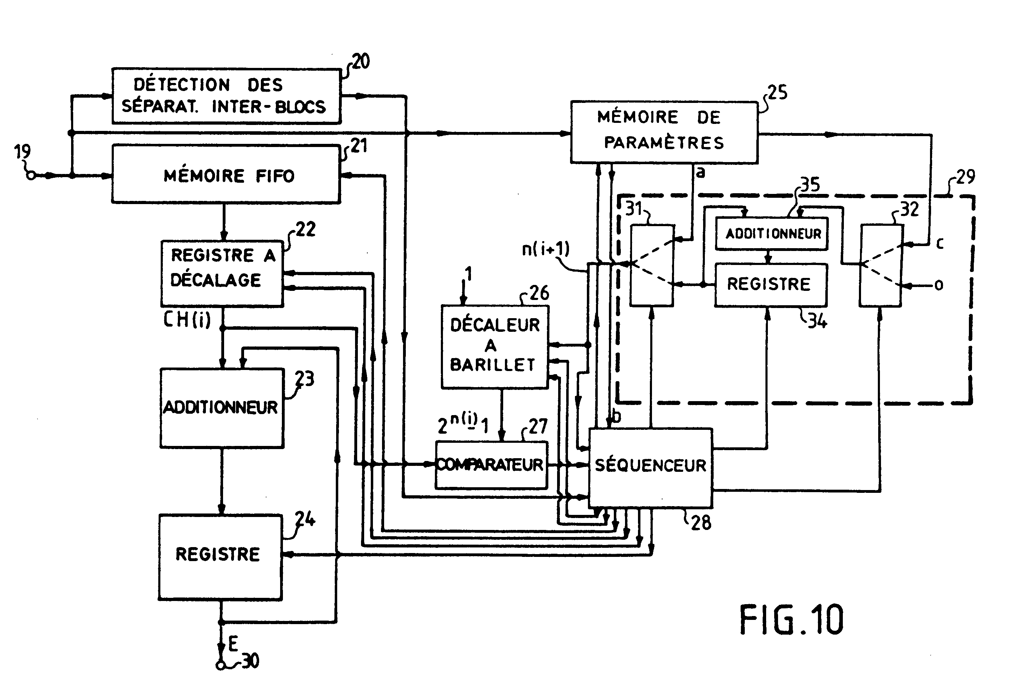

La figure 10 représente le schéma synoptique d'un dispositif de décodage selon l'invention, pour décoder une suite de mots de code fournis par un dispositif de codage tel que celui représenté sur la figure 9, c'est-à-dire des mots de code correspondant à un arbre de codage choisi parmi 8 arbres. Cet exemple de réalisation comporte : une borne d'entrée 19 ; un dispositif 20 de détection des séparateurs inter-blocs ; une mémoire FIFO 21, ayant une capacité correspondant à un bloc de 16x16 valeurs à décoder ; un registre à décalage 22 ; un additionneur 23 ; un registre 24 ; une mémoire de paramètres, 25 ; un décaleur à barillet, 26 ; un comparateur 27 ; un séquenceur 28 ; des moyens de calcul 29 ; et une borne de sortie 30.

La borne d'entrée 19 est reliée à une entrée du dispositif 20 et à une entrée série de la mémoire FIFO 21 et à une entrée de la mémoire 25. Une sortie du dispositif 20 est reliée à une entrée du séquenceur 28. Une sortie de la mémoire 21 est reliée une entrée série du registre 22. Une sortie du registre 22 est reliée à une première entrée de l'additionneur 23. Une seconde entrée de l'additionneur 23 est reliée à une sortie du registre 24. Une sortie de l'additionneur 23 est reliée à une entrée de données du registre 24. La borne de sortie 30 du dispositif de décodage est reliée à la sortie du registre 24.

Une première entrée du comparateur 27 est reliée à une sortie du décaleur 26. Une seconde entrée du comparateur 27 est reliée à la sortie du registre 22. La sortie du comparateur 27 est reliée à une entrée du séquenceur 28. Le registre 22 comporte une entrée de remise à zéro et une entrée d'horloge reliées respectivement à deux sorties du séquenceur 29. La mémoire 21 et le registre 24 comportent chacun une entrée de commande reliée respectivement à des sorties du séquenceur 28. La mémoire de paramètres, 25, comporte une entrée d'adresse reliée à une sortie du séquenceur 28, et trois sorties reliées respectivement à une première et une deuxième entrée des moyens de calcul 29 pour leur fournir respectivement les valeurs a, b, et à une entrée du séquenceur 28 pour lui fournir une valeur b. Le décaleur 26 comporte : une entrée de données recevant une valeur 1 permanente, une entrée de remise à zéro et une entrée d'horloge reliées respectivement à deux sorties du séquenceur 28 ; et une entrée de commande reliée à une sortie des moyens de calcul 29. Cette sortie est reliée aussi à une entrée du séquenceur 28.

Les moyens de calcul 29 comportent : deux multiplexeurs, 31 et 32, à deux entrées et une sortie ; un additionneur 33 ; et un registre 34. Une première entrée du multiplexeur 31 est reliée à la première entrée des moyens 29. Une seconde entrée du multiplexeur 31 est reliée à la sortie du registre 34, cette sortie étant reliée aussi à une première entrée de l'additionneur 33. Une seconde entrée de l'additionneur 33 est reliée à la sortie du multiplexeur 32. La sortie de l'additionneur 33 est reliée à l'entrée de données du registre 34. La sortie du multiplexeur 31 constitue la sortie des moyens 29. Une première entrée du multiplexeur 32 reçoit en permanence la valeur zéro et une seconde entrée est reliée à la deuxième entrée des moyens 29. Les multiplexeurs 31 et 32, et le registre 34 possèdent respectivement des entrées de commande reliées respectivement à trois sorties du séquenceur 28.

Une suite de mots de code est appliquée sous forme série à la borne d'entrée 19. Les mots de code correspondant à un bloc de valeurs sont précédés d'un séparateur inter-blocs qui est reconnu par le dispositif 20 de détection des séparateurs inter-blocs, et sont précédés de la valeur en clair des paramètres a, b, c. La valeur des paramètres est stockée dans la mémoire 25 sous l'action d'un signal de commande fourni par le séquenceur 28. Les trois sorties de la mémoire 25 fournissent respectivement : la valeur du paramètre a et la valeur du paramètre c à la première et à la seconde entrée des moyens de calcul 29 ; et fournissent la valeur du paramètre b à une entrée du séquenceur 28, pour permettre le calcul de la suite de valeurs $n(i)$ selon la loi arithmétique définie par la valeur de ces paramètres. Le séquenceur 28 comporte un compteur interne pour compter les valeurs entières $i$ à partir de 1 et pour commander le calcul de la suite de valeurs $n(i)$ dans les moyens de calcul 29. Ces derniers fonctionnent comme les moyens de calcul 16 de la figure 8.

A l'instant considéré, la sortie des moyens 29 fournit la valeur $n(i)$ à une entrée de commande du décaleur à barillet 26 ; et le séquenceur 28 fournit des signaux de commande au décaleur 26 pour qu'il fournisse un mot binaire ayant une valeur égale à $2^{n(i)}-1$. Cette valeur est appliquée à une première entrée du comparateur 27. La mémoire FIFO 21 possède une entrée de commande d'écriture, non représentée, reliée à un dispositif classique de restitution du rythme du canal de transmission des données codées. Ce dispositif commande le stockage des données codées dans la mémoire 21. Elle possède en outre une entrée de commande de lecture, reliée à une sortie du séquenceur 28. Chaque fois qu'une valeur $n(i)$ est calculée, le séquenceur 28 commande la mémoire 21 pour lire $n(i)$ bits des mots de code stockés dans la mémoire 21. Ces $n(i)$ bits sont stockés successivement dans le registre 22. Pour cela le séquenceur 28 commande une remise à zéro du registre 22 puis commande l'écriture des $n(i)$ bits appliqués successivement à l'entrée série du registre 22.

A l'instant considéré, la sortie du registre 22 fournit un mot de seize bits, dont les $n(i)$ bits de poids faible sont des bits de données codées et dont les $(16-n(i))$ bits de poids fort ont une valeur nulle. La valeur de ce mot binaire est noté $CH(i)$. Elle est appliquée à une première entrée de l'additionneur 23 et à une seconde entrée du comparateur 27.

Le comparateur 27 compare la valeur du mot binaire $CH(i)$ avec la valeur $2^{n(i)}-1$. Le séquenceur 28 incrémente $i$ et calcule de nouvelles valeurs $n(i)$ croissantes jusqu'à ce que pour une valeur $i_o$ de $i$, la valeur $CH(i_o)$ est strictement inférieure à $2^{n(i_o)}-1$. Ceci est dé-

tecté par le comparateur 27 lorsque i prend la valeur $i_o$. Le séquenceur 28 arrête alors d'incrémenter i. L'additionneur 23 et le registre 24 accumulent les valeurs CH(i) pour i variant de 1 à $i_o$, le registre 24 étant commandé par un signal d'horloge que lui fournit le séquenceur 28 pour chaque nouvelle valeur de i. La sortie du registre 24 fournit donc une valeur qui est égale à la somme de CH(i) = $2^{n(i)}-1$ pour i égal à 1 à $i_o$-1, plus la valeur CH($i_o$) du dernier champ correspondant à $i_o$. Le registre 24 fournit donc une valeur décodée E. Cette valeur E est fournie à la borne de sortie 30 du dispositif de décodage.

Il est à la portée de l'homme de l'art d'adapter le dispositif de codage et le dispositif de décodage pour utiliser deux arbres de codage distincts ou deux ensembles d'arbres de codage distincts pour coder d'une part des valeurs positives et d'autre part des valeurs négatives, selon le procédé décrit précédemment.

L'invention est avantageuse pour le codage de tout type d'événements pouvant être représentés facilement par une suite de valeurs entières consécutives, positives ou nulles, dont les probabilités sont décroissantes quand les valeurs augmentent. C'est le cas, notamment, des valeurs d'une variable dont la probabilité est monotone décroissante de part et d'autre de sa valeur moyenne. Cette représentation est considérée comme facile lorsqu'elle ne nécessite pas de mémoire morte de transcodage.

L'invention est applicable notamment au codage des coefficients obtenus par une transformation cosinus appliquée à des blocs de valeurs représentant des blocs d'éléments d'image vidéo. La distribution statistique des valeurs de coefficients de transformation varie d'un bloc d'éléments d'image à un autre, il est donc avantageux d'adapter le codage, en utilisant un arbre de codage différent éventuellement pour chaque bloc d'éléments d'image. Le codage à longueur variable des coefficients de transformation est alors optimisé pour chaque bloc alors qu'un codage de Huffmann classique est optimisé une fois pour toutes à partir de la distribution statistique des valeurs de coefficients correspondant à un certain nombre d'images considérées comme typiques.

La réalisation d'un dispositif de codage adaptatif et d'un dispositif de décodage adaptatif pour la mise en oeuvre du procédé selon l'invention est particulièrement simple et peu coûteuse, ce qui permet de réaliser un codage adaptatif qui serait trop coûteux à réaliser au moyen de mémoires mortes mémorisant plusieurs arbres de codage de Huffmann optimisés.

**Revendications**

1. Procédé de codage à longueur variable, pour coder une suite de valeurs entières consécutives, positives ou nulles, dont la probabilité d'apparition décroît en fonction de la valeur, consistant, pour coder chaque valeur E, à :
   - déterminer un premier mot binaire comportant un nombre de bits B ayant une même valeur, B étant égal à la somme de n(i) pour i = 1 à $i_o$-1, où n(i) est un nombre entier fonction d'une variable entière i, et $i_o$ est un nombre entier fonction de E et tel que E est strictement supérieure à la somme de ($2^{n(i)}-1$) pour i = 1 à $i_o$-1, et inférieure ou égale à la somme de ($2^{n(i)}-1$) pour i = 1 à $i_o$ ;
   - déterminer un second mot binaire ayant une valeur égale à la différence entre E et la somme de ($2^{n(i)}-1$) pour i = 1 à $i_0$ -1 et un nombre de bit B' égal à n($i_0$) ;
   - constituer un mot de code réunissant le premier et le second mot binaire ainsi déterminés,
      caractérisé en ce que n(1) prend la valeur a
      et n(i) prend la valeur n(i-1) si (i-1) (modulo b) est entre 1 et b-1 inclus ;
      et n(i) prend la valeur n(i-1) + c si (i-1) (modulo b) = 0 ; a,b,c étant des constantes entières fixées.

2. Procédé de codage selon la revendication 1, caractérisé en ce qu'il consiste en outre à :
   - définir, pour une même suite de valeurs à coder, plusieurs ensembles de mots de code, correspondant à des répartitions statistiques différentes des valeurs à coder, chaque ensemble étant défini par le nombre des bits B et B', qui est une fonction B(E) différente et caractérisée par la valeur d'un jeu de paramètres ;
   - calculer le coût de codage de la suite de valeurs à coder, pour chaque ensemble de mots de code, et déterminer quel ensemble de mots de code procure le moindre coût de codage ;
   - coder les valeurs à coder, au moyen des mots de code de cet ensemble, en adjoignant un mot représentant les paramètres de la fonction B(E) correspondant à cet ensemble de mots de code.

3. Procédé de codage a longueur variable, pour coder une suite finie de valeurs entières relatives et consécutives, dont la probabilité d'apparition décroît en fonction de la valeur absolue, mais est la même quel que soit le signe de la valeur à coder, caractérisé en ce qu'il consiste à :
   - représenter la suite des valeurs relatives par une suite de valeurs entières consécutives, positives ou nulles, chaque valeur à coder étant représentée par un mot binaire dont les bits de plus fort poids sont constitués par les bits représentant la valeur absolue de la valeur à coder et dont le bit de plus faible poids est constitué par le bit de signe de la valeur à coder ;
- coder la suite de valeurs entières positives ou nulles, en mettant en oeuvre le procédé selon la revendication 1.

4. Procédé de codage à longueur variable, pour coder une suite finie de valeurs entières relatives consécutives, dont la probabilité d'apparition décroît en fonction de la valeur absolue et varie en fonction du signe de la valeur à coder, caractérisé en ce qu'il consiste à :
- représenter la suite des valeurs relatives par deux suites de valeurs entières consécutives positives et par une valeur nulle, correspondant respectivement aux valeurs à coder positives, aux valeurs à coder négatives, et à une valeur nulle, chaque valeur à coder étant représentée par sa valeur absolue ;
- coder différemment ces deux suites de valeurs positives en mettant en oeuvre le procédé selon la revendication 1, avec les nombres des bits B et B', qui sont deux fonctions B(E) différentes pour minimiser respectivement le coût de codage de ces deux suites ;
- adjoindre à chaque mot de code ainsi obtenu un mot binaire de deux bits indiquant si la valeur codée est positive, négative ou nulle.

5. Procédé de décodage pour décoder une suite de valeurs entières consécutives, positives ou nulles, codées par le procédé selon la revendication 1, caractérisé en ce que pour décoder chaque valeur, il consiste à :
- rechercher parmi les premiers bits à décoder, un premier mot binaire ne comportant que des bits ayant une même valeur prédéterminée, et ayant un nombre de bits maximal et égal à l'une des valeurs d'une suite de valeurs entières définie par les nombres des bits B et B', qui sont la fonction B(E) mise en oeuvre pour le codage ;
- déterminer un second mot binaire constitué de bits suivant ceux du premier mot binaire et dont le nombre est déduit de la fonction B(E) mise en oeuvre pour le codage, et du nombre de bits déterminé pour le premier mot binaire ;
- déterminer la valeur décodée, en additionnant une valeur entière prédéterminée correspondant au nombre de bits du premier mot binaire par la fonction B(E), et la valeur du second mot binaire.

6. Procédé de décodage selon la revendication 5, pour décoder des événements codés par le procédé selon la revendication 1, caractérisé en ce que pour déterminer la valeur entière prédéterminée correspondant au nombre de bits du premier mot binaire, il consiste, pour i entier croissant à partir de 1, à :
- calculer une suite de nombres entiers $n(i)$ selon une loi arithmétique et logique identique à celle mise en oeuvre pour le codage ;
- déterminer la valeur binaire $CH(i)$ d'un mot binaire constitué de $n(i)$ bits consécutifs de la suite de bits à décoder, ces $n(i)$ bits étant distincts pour chaque valeur de i ;
- comparer $CH(i)$ respectivement à la valeur $2^{n(i-1)}$ ;

et consiste à déterminer une valeur maximale $i_0$ de i, telle que $CH(i_0-1)$ est égal à $2^{n(i_0-1)}$ ;

et consiste à additionner les valeurs $CH(i)$, pour i croissant de 1 jusqu'à $i_0$ inclus, la valeur de cette somme correspondant au rang de la valeur à décoder dans l'ensemble des valeurs décodées possibles, ordonné dans l'ordre des probabilités décroissantes.

7. Dispositif de codage pour la mise en oeuvre du procédé de codage selon la revendication 1, pour coder une suite de valeurs entières consécutives, positives ou nulles, dont les probabilités décroissent selon les valeurs croissantes, caractérisé en ce qu'il comporte :
- des premiers moyens de calcul (16) pour calculer une suite de valeurs entières $n(i)$ selon une loi de progression prédéterminée, pour des valeurs entières i croissant à partir de 1 ;
- des seconds moyens de calcul (5 à 7, 13, 14) pour calculer une suite de valeurs entières $S(i)$, $S(i)$ étant égale à la somme de $(2^{n(u)}-1)$ pour des valeurs entières u croissant de 1 à i, et pour comparer la valeur $S(i)$ a une valeur à coder E ; et déterminer une valeur $i_0$ telle que E est strictement supérieure à $S(i_0-1)$ et inférieure ou égale à $S(i_0)$ ;
- des troisièmes moyens de calcul (15, 17) pour former un mot binaire ayant $B(i_0-1)$ bits ayant une valeur identique prédéterminée, $B(i_0-1)$ étant égal à la somme de $n(i)$ pour i=1 à $i_0-1$ ;
- des moyens (3, 4) pour constituer un mot de code comportant une première partie constituée par le mot binaire de $B(i_0-i)$ bits ayant une valeur identique prédéterminée ; et une seconde partie constituée par un mot binaire dont la valeur est $E-S(i_0-1)$.

8. Dispositif de codage selon la revendication 7, caractérisé en ce que les premiers moyens de calcul (16) comportent un circuit arithmétique et logique (9 à 13) pour calculer une valeur n(i), pour i entier croissant à partir de 1, selon les formules :

$$n(1) = a$$

$$n(i) = n(i-1) \text{ si } (i-1) \text{ (modulo b) est entre 1 et b-1 inclus ;}$$

$$n(i) = n(i-1) + c \text{ si } (i-1) \text{ (modulo b)} = 0 ;$$

a, b, c étant des constantes entières positives fixées.

9. Dispositif de codage pour la mise en oeuvre du procédé selon la revendication 2, caractérisé en ce qu'il comporte :

   - une pluralité de dispositifs de codage (41 à 48) selon la revendication 1, pour coder chaque valeur à coder, selon une pluralité d'ensemble de mots de code, chaque ensemble étant défini par la valeur d'un jeu de paramètres ;
   - une pluralité de dispositifs (61 à 68) pour calculer le coût de codage d'un bloc de valeurs à coder, respectivement pour chaque ensemble de mots de code ;
   - des moyens (70) pour déterminer quel ensemble de mots de code procure le moindre coût de codage pour un bloc de valeurs à coder donné ;
   - des moyens (51 à 58) pour stocker les valeurs codées correspondant à un bloc de valeurs à coder, pour chaque ensemble de mots de code ;
   - des moyens (69, 71, 72) pour relire dans les moyens pour stocker (51 à 58), les valeurs codées correspondant à l'ensemble de mots de code procurant le moindre coût de codage ;
   - des moyens (72) pour transmettre ces valeurs codées en leur adjoignant la valeur du jeu de paramètres définissant l'ensemble de mots de code procurant le moindre coût de codage.

10. Dispositif de décodage pour la mise en oeuvre du procédé selon la revendication 5, pour décoder des valeurs ayant été codées par le procédé selon la revendication 1, caractérisé en ce qu'il comporte :

   - des moyens (21) pour stocker les bits de la suite des valeurs codées ;
   - des premiers moyens de calcul (29) pour calculer une suite de valeurs entières n(i) selon une loi arithmétique et logique prédéterminée identique à celle mise en oeuvre pour le codage, pour des valeurs entières de i croissant à partir de 1 ;
   - des seconds moyens de calcul (22, 26 à 28) pour calculer une valeur $2^{n(i)}-1$ pour chaque valeur n(i) ; lire, dans les moyens pour stocker (21), un champ constitué de n(i) bits consécutifs des valeurs codées, distincts pour chaque valeur de la suite n(i) ; déterminer la valeur CH(i) de ce champ ; et déterminer une valeur $i_0$ de i telle que $CH(i_0)$ est strictement supérieure à $2^{n(i_0 - 1)}-1$ et inférieure ou égale à $2^{n(i_0)}-1$ ;

   - des troisièmes moyens de calcul (23, 24) pour additionner les valeurs CH(i) pour i croissant de 1 à $i_0$, la valeur de cette somme correspondant au rang de la valeur à décoder, dans l'ensemble des valeurs décodées possibles, ordonné dans l'ordre des probabilités décroissantes.

11. Dispositif de décodage selon la revendication 10, pour la mise en oeuvre du procédé selon la revendication 6, caractérisé en ce que les premiers moyens de calcul (29) comportent un circuit arithmétique et logique (31 à 34), pour calculer une valeur n(i), pour i entier croissant à partir de 1, selon les formules :

$$n(1) = a$$

$$n(i) : n(i-1) \text{ si } (i-1) \text{ (modulo b) est entre 1 et b-1 inclus ;}$$

$$n(i) = n(i-1) + c \text{ si } (i-1) \text{ (modulo b)} = 0 ; a, b, c \text{ étant des constantes entières positives fixées.}$$

12. Dispositif de décodage selon la revendication 10, pour décoder des valeurs codées par le procédé selon la revendication 2, caractérisé en ce que les premiers moyens de calcul (29) calculent une suite de valeurs n(i) en fonction de la valeur d'un jeu de paramètres, qui est variable pour chaque bloc de valeurs à coder, la valeur du jeu de paramètres étant transmise avec les valeurs codées.

**Patentansprüche**

1. Verfahren zur Kodierung mit variabler Kodelänge, um eine Folge von ganzzahligen, aufeinanderfolgenden, positiven Werten einschließlich Null zu kodieren, deren Wahrscheinlichkeit des Auftretens abhängig vom Wert abnimmt, wobei das Verfahren zur Kodierung jedes Werts folgende Schritte aufweist:

   - Bestimmung eines ersten Binärworts aus einer Anzahl B von Bits eines gleichen Werts, wobei B die Summe von n(i) für Werte i = 1 bis $i_0-1$ ist und n(i) eine ganze Zahl ist, die von einer ganzzahligen Variablen i abhängt und wobei $i_0$ eine ganze Zahl ist, die von E abhängt, derart, daß E größer als die Summe von $(2^{n(i)}-1)$ für i = 1 bis i = $i_0-1$ und kleiner oder gleich der Summe von

$(2^{n(i)}-1)$ für i = 1 bis i = $i_0$ ist,
- Bestimmung eines zweiten Binärworts, dessen Wert gleich der Differenz zwischen E und der Summe von $(2^{n(i)}-1)$ für i = 1 bis i = $i_0$-1 ist und das eine Anzahl von Bits B' = $n(i_0)$ enthält,
- Bildung eines Kodeworts, das die so bestimmten beiden Binärwörter zusammenfügt,

dadurch gekennzeichnet, daß

n(1) den Wert a annimmt,

und n(i) den Wert n(i-1) annimmt, wenn (i-1)$_{modulo\ b}$ zwischen 1 und b-1 einschließlich liegt,

und n(i) den Wert n(i-1)+c annimmt, wenn (i-1)$_{modulo\ b}$ Null ist, wobei a, b, c feste ganzzahlige Konstanten sind.

2. Verfahren zur Kodierung nach Anspruch 1, dadurch gekennzeichnet, daß es außerdem darin besteht
- für eine gleiche Folge von zu kodierenden Werten mehrere Gruppen von Kodewörtern zu definieren, die unterschiedlichen statistischen Verteilungen der zu kodierenden Werte entsprechen, wobei jede Gruppe durch die Anzahl von Bits B und B' definiert wird, die eine unterschiedliche und durch den Wert eines Parametersatzes gekennzeichnete Funktion B(E) ist,
- den Aufwand zur Kodierung der Folge von zu kodierenden Werten für jede Gruppe von Kodewörtern zu berechnen und festzulegen, welche Gruppe von Kodierwörtern den geringsten Kodieraufwand bietet,
- die zu kodierenden Werte mit Hilfe der Kodewörter dieser Gruppe zu kodieren, indem ein Wort hinzugefügt wird, das die Parameter der Funktion B(E) entsprechend dieser Gruppe von Kodewörtern darstellt.

3. Kodierverfahren mit variabler Länge zur Kodierung einer endlichen Folge von ganzzahligen relativen und aufeinanderfolgenden Werten, deren Wahrscheinlichkeit des Auftretens abhängig vom Absolutwert abnimmt, die aber unabhängig vom Vorzeichen des zu kodierenden Werts gleich bleibt, dadurch gekennzeichnet, daß es darin besteht,
- die Folge von relativen Werten durch eine Folge von ganzzahligen aufeinanderfolgenden positiven Werten einschließlich Null darzustellen, wobei jeder zu kodierende Wert durch ein Binärwort dargestellt wird, dessen Bits hoher Wichtung von den Bits des Absolutwerts des zu kodierenden Werts gebildet werden und dessen Bit geringster Wichtung vom Vorzeichenbit des zu kodierenden Werts gebildet wird,

- die Folge von ganzzahligen positiven Werten einschließlich Null unter Verwendung des Verfahrens nach Anspruch 1 zu kodieren.

4. Kodierverfahren mit variabler Länge zur Kodierung einer endlichen Folge von ganzzahligen relativen und aufeinanderfolgenden Werten, deren Wahrscheinlichkeit des Auftretens abhängig vom Absolutwert abnimmt und abhängig vom Vorzeichen des zu kodierenden Werts variiert, dadurch gekennzeichnet, daß es darin besteht,
- die Folge der relativen Werte durch zwei Folgen von ganzzahligen aufeinanderfolgenden positiven Werten und durch einen Wert Null entsprechend den positiven oder negativen zu kodierende Werten oder dem zu kodierenden Wert Null darzustellen, wobei jeder zu kodierende Wert durch seinen Absolutwert dargestellt wird,
- die beiden Folgen von positiven Werten zu kodieren, indem das Verfahren nach Anspruch 1 angewendet wird, und zwar mit der Anzahl von Bits B und B', die zwei unterschiedliche Funktionen B(E) sind, um den Kodieraufwand dieser beiden Folgen zu minimieren,
- jedem so erhaltenen Kodewort ein Binärwort aus zwei Bits hinzuzufügen, das angibt, ob der kodierte Wert positiv, negativ oder null ist.

5. Dekodierverfahren zur Dekodierung einer Folge von ganzzahligen, aufeinanderfolgenden, positiven Werten einschließlich null, die durch das Verfahren nach Anspruch 1 kodiert wurden, dadurch gekennzeichnet, daß zur Dekodierung jedes Werts das Verfahren darin besteht,
- unter den zu dekodierenden ersten Bits ein erstes Binärwort zu suchen, das nur Bits mit einem vorbestimmten gleichen Wert sowie eine maximale Bitanzahl gleich einem der Werte einer Folge von ganzzahligen Werten hat, die durch die Anzahl von Bits B und B' definiert sind, welche von der für die Kodierung eingesetzten Funktion B(E) abhängt,
- ein zweites Binärwort zu bestimmen, das aus Bits gebildet wird, die auf die des ersten Binärworts folgen und deren Anzahl aus der für die Kodierung eingesetzten Funktion B(E) und aus der für das erste Binärwort bestimmten Anzahl von Bits abgeleitet wird,
- den dekodierten Wert durch Addition eines ganzzahligen und durch die Funktion B(E) vorbestimmten Werts entsprechend der Anzahl von Bits des ersten Binärworts und des Werts des zweiten Binärworts zu bestimmen.

6. Verfahren zur Dekodierung nach Anspruch 5, um gemäß dem Verfahren nach Anspruch 1 kodierte Zustände zu dekodieren, dadurch gekennzeichnet, daß zur Bestimmung des ganzzahligen vorbestimmten Werts entsprechend der Anzahl von Bits des ersten Binärworts das Verfahren darin besteht, für ganzzahlige und vom Wert 1 ansteigende Werte von i

- eine Folge von ganzen Zahlen n(i) gemäß einem arithmetischen und logischen Gesetz zu berechnen, das dem für die Kodierung verwendeten gleicht,
- den Binärwert CH(i) eines Binärworts zu bestimmen, das von n(i) aufeinanderfolgenden Bits der zu dekodierenden Bitfolge gebildet wird, wobei diese n(i) Bits für jeden Wert von i unterschiedlich sind,
- CH(i) jeweils mit dem Wert $2^{n(i-1)}$ zu vergleichen, und daß das Verfahren weiter darin besteht, einen Maximalwert $i_0$ von i so zu bestimmen, daß gilt: $CH(i_0-1) = 2^{n(i_0-1)}$

und daß das Verfahren darin besteht, die Werte CH(i) für von 1 bis $i_0$ einschließlich ansteigende Werte von i zu addieren, wobei der Wert dieser Summe dem Rang des zu kodierenden Werts in der Gruppe von möglichen dekodierten Werten entspricht, und zwar in der Reihenfolge der abnehmenden Wahrscheinlichkeit.

7. Kodiervorrichtung zur Durchführung des Kodierverfahrens nach Anspruch 1, um eine Folge von ganzzahligen positiven Werten einschließlich null zu kodieren, deren Wahrscheinlichkeiten gemäß steigenden Werten abnehmen, dadurch gekennzeichnet, daß sie aufweist:

- erste Rechenmittel (16) zur Berechnung einer Folge von ganzzahligen Werten n(i) gemäß einem vorbestimmten Progressionsgesetz für ganzzahlige Werte i, die vom Wert 1 aus ansteigen,
- zweite Rechenmittel (5 bis 7, 13, 14), um eine Folge von ganzzahligen Werten S(i) zu berechnen, wobei S(i) der Summe von $(2^{n(u)}-1)$ für ganzzahlige, von 1 bis i steigende Werte von n gleicht, und um den Wert S(i) mit einem zu kodierenden Wert E zu vergleichen sowie um einen Wert $i_0$ zu bestimmen, derart, daß E größer als $S(i_0-1)$ und kleiner oder gleich $S(i_0)$ ist,
- dritte Rechenmittel (15, 17), um ein Binärwort zu bilden, das $B(i_0-1)$ Bits eines identischen vorbestimmten Werts besitzt, wobei $B(i_0-1)$ gleich der Summe von n(i) für i = 1 bis i = $i_0$ -1 ist,
- Mittel (3, 4), um ein Kodewort mit einem ersten Teil, der aus dem Binärwort mit $B(i_0-1)$ Bits des gleichen vorbestimmten Werts besteht, und mit einem zweiten Teil zu bilden, der aus einem Binärwort besteht, dessen Wert $E-S(i_0-1)$ ist.

8. Kodiervorrichtung nach Anspruch 7, dadurch gekennzeichnet, daß die ersten Rechenmittel (16) eine arithmetische und logische Schaltung (9 bis 13) besitzen, um einen Wert n(i) für ganzzahlige, von 1 ansteigende Werte von i gemäß folgenden Formeln zu berechnen:

$n(1) = a$

$n(i) = n(i-1)$, wenn $(i-1)_{modulo\ b}$ zwischen 1 und b-1 einschließlich liegt,

$n(i) = n(i-1)+c$, wenn $(i-1)_{modulo\ b} = 0$,

wobei a, b, c ganzzahlige positive feste Konstanten sind.

9. Kodiervorrichtung zur Durchführung des Verfahrens nach Anspruch 2, dadurch gekennzeichnet, daß sie aufweist

- eine Mehrzahl von Kodiervorrichtungen (41 bis 48) gemäß Anspruch 1, um jeden zu kodierenden Wert gemäß einer Mehrzahl von Gruppen von Kodierwörtern zu kodieren, wobei jede Gruppe durch den Wert eines Parametersatzes definiert ist,
- eine Mehrzahl von Vorrichtungen (61 bis 68) zur Berechnung des Kodieraufwands eines zu kodierenden Blocks von Werten, und zwar für jede Gruppe von Kodewörtern,
- Mittel (70), um zu bestimmen, welche Gruppe von Kodewörtern den geringsten Kodieraufwand für einen gegebenen Block von zu kodierenden Werten bietet,
- Mittel (51 bis 58), um die kodierten Werte entsprechend einem Block von zu kodierenden Werten für jede Gruppe von Kodewörtern zu speichern,
- Mittel (69, 71, 72), um aus den Speichermitteln (51 bis 58) die kodierten Werte entsprechend der Gruppe von Kodewörtern auszulesen, die den geringsten Kodieraufwand bietet,
- Mittel (72), um diese kodierten Werte zu übertragen, indem ihnen der Wert des Parametersatzes zugefügt wird, der die Gruppe von Kodewörtern mit dem geringsten Kodieraufwand definiert.

10. Dekodiervorrichtung zur Durchführung des Verfahrens nach Anspruch 5 und um Werte zu dekodieren, die durch das Verfahren nach Anspruch 1 kodiert worden sind, dadurch gekennzeichnet, daß sie aufweist:

- Mittel (21) zur Speicherung der Bits der Folge der kodierten Werte,

- erste Rechenmittel (29), um eine Folge von ganzzahligen Werten n(i) gemäß einem bestimmten arithmetischen und logischen Gesetz, das dem bei der Kodierung verwendeten gleicht, für ganzzahlige Werte von i ausgehend vom Wert 1 zu berechnen,

- zweite Rechenmittel (22, 26 bis 28), um einen Wert $2^{n(i)}-1$ für jeden Wert n(i) zu berechnen, aus den Speichermitteln (21) ein Feld bestehend aus für jeden Wert der Folge n(i) unterschiedlichen n(i) aufeinanderfolgenden Bits der kodierten Werte auszulesen, den Wert CH(i) dieses Feldes zu bestimmen und einen Wert $i_0$ von i so zu bestimmen, daß $CH(i_0)$ größer als $2^{n(i_0-1)}-1$ und kleiner oder gleich $2^{n(i_0)}-1$ ist,

- dritte Rechenmittel (23, 24), um die Werte CH(i) für von 1 bis $i_0$ steigende Werte i zu addieren, wobei der Wert dieser Summe dem Rang des zu dekodierenden Werts in der Gruppe von möglichen dekodierten Werten entspricht, und zwar in der Reihenfolge abnehmender Wahrscheinlichkeiten.

11. Vorrichtung zur Dekodierung nach Anspruch 10 zur Durchführung des Verfahrens nach Anspruch 6, dadurch gekennzeichnet, daß die ersten Rechenmittel (29) eine arithmetische und logische Schaltung (31 bis 34) besitzen, um einen Wert n(i) für ganzzahligen, von 1 ansteigenden Wert von i gemäß folgenden Formeln zu berechnen:

n(1) = a

n(i) = n(i-1), wenn $(i-1)_{modulo\ b}$ zwischen 1 und b-1 einschließlich liegt,

n(i) = n(i-1)+c, wenn $(i-1)_{modulo\ b}$ = 0, wobei a, b, c feste positive ganzzahlige Konstanten sind.

12. Dekodiervorrichtung nach Anspruch 10 zur Dekodierung der nach dem Verfahren gemäß Anspruch 2 kodierten Werte, dadurch gekennzeichnet, daß die ersten Rechenmittel (29) eine Folge von Werten n(i) abhängig vom Wert eines Parametersatzes berechnen, der für jeden Block von zu kodierenden Werten variabel ist, wobei der Wert des Parametersatzes mit den kodierten Werten übertragen wird.

**Claims**

1. Variable length encoding method for encoding a series of consecutive, positive or zero, integer values whose probability of occurrence decreases as a function of the value, consisting, in order to encode each value E, in:

- determining a first binary word including a number of bits B having the same value, B being equal to the sum of n(i) for i=1 to $i_0$-1,

where n(i) is an integer number which is a function of a variable integer i, and $i_0$ is an integer number which is a function of E and such that E is strictly greater than the sum of $(2^{n(i)}-1)$ for i=1 to $i_0$-1, and less than or equal to the sum of $(2^{n(i)}-1)$ for i=1 to $i_0$;

- determining a second binary word having a value equal to the difference between E and the sum of $(2^{n(i)}-1)$ for i=1 to $i_0$-1 and a number of bits B' equal to $n(i_0)$;

- constituting a code word by combining the first and second binary words thus determined, characterized in that

n(1) takes the value a

and n(i) takes the value n(i-1) if (i-1) (modulo b) is between 1 and b-1 inclusive;

and n(i) takes the value n(i-1) + c if (i-1)(modulo b) = 0; a, b, c being fixed integer constants.

2. Encoding method according to Claim 1, characterized in that it furthermore consists in:

- defining, for a same series of values to be encoded, several sets of code words, corresponding to different statistical distributions of values to be encoded, each set being defined by the number of bits B and B', which is a different function B(E) and characterized by the value of a set of parameters;

- computing the encoding cost of the series of values to be encoded, for each set of code words, and determining which set of code words provide the minimum encoding cost;

- encoding the values to be encoded, by means of the code words of this set, attaching a word representing the parameters of the function B(E) corresponding to this set of code words.

3. Variable length encoding method, for encoding a finite series of consecutive relative integer values, whose probability of occurrence decreases as a function of the absolute value, but is the same whatever the sign of the value to be encoded may be, characterized in that it consists in:

- representing the series of relative values by a series of consecutive, positive or zero, integer values, each value to be encoded being represented by a binary word whose most significant bits are constituted by the bits representing the absolute value of the value to be encoded and whose least significant bit is constituted by the sign bit of the value to be encoded;

- encoding the series of positive or zero integer values by implementing the method according to Claim 1.

4. Variable length encoding method, for encoding a finite series of consecutive relative integer values, whose probability of occurrence decreases as a function of the absolute value and varies as a function of the sign of the value to be encoded, characterized in that it consists in:
- representing the series of relative values by two series of positive consecutive integer values and a zero value, respectively corresponding to the positive values to be encoded, the negative values to be encoded and a zero value, each value to be encoded being represented by its absolute value;
- differently encoding these two series of positive values by implementing the method according to Claim 1, with the numbers of bits B and B', which are two different functions B(E) in order to respectively minimize the encoding costs of these two series;
- attaching to each code word thus obtained a two-bit binary word indicating if the encoded value is positive, negative or zero.

5. Decoding method for decoding a series of positive or zero consecutive integer values, encoded by the method according to Claim 1, characterized in that in order to decode each value, it consists in:
- seeking among the first bits to be decoded a first binary word containing only bits having a same predetermined value, whose number of bits is a maximum and equal to one of the values of a series of integer values defined by the numbers of bits B and B', which are the function B(E) used for the encoding;
- determining the second binary word constituted of bits following those of the first binary word and whose number is derived from the function B(E) used for the encoding, and from the number of bits determined for the first binary word;
- determining the decoded value, by adding an integer value corresponding to the number of bits of the first binary word predetermined by the function B(E), and the value of the second binary word.

6. Decoding method according to Claim 5, for decoding events encoded by the method according to Claim 1, characterized in that in order to determine the predetermined integer value corresponding to the number of bits of the first binary word, it consists, for the integer i increasing from 1, in:
- computing a series of integer numbers n(i) according to an arithmetic and logic law identical to that used for the encoding;
- determining the binary value (CH(i) of a binary word constituted of n(i) consecutive bits of the series of bits to be decoded, these n(i) bits being separate for each value of i;
- comparing CH(i) respectively with the value $2^{n(i-1)}$;

and consists in determining a maximum value $i_0$ of i, such that $CH(i_0-1)$ is equal to $2^{n(i_0-1)}$;

and consists in adding the values CH(i), for i increasing from 1 to $i_0$ inclusive, the value of this sum corresponding to the rank of the value to be decoded in the set of possible decoded values, arranged in order of decreasing probability.

7. Encoding device for the implementation of the encoding method according to Claim 1, for encoding a series of consecutive positive or zero integer values, whose probabilities decrease according to the increasing values, characterized in that it comprises:
- first means of computation (16) for computing a series of integer values n(i0 according to a predetermined law or progression, for integer values i increasing from 1;
- second means of computation (5 to 7, 13, 14) for computing a series of integer values S(i), S(i) being equal to the sum of $(2^{n(u)}-1)$ for integer values u increasing from 1 to i, and for comparing the value S(i) with a value to be encoded E; and determining a value $i_0$ such that E is strictly greater than $S(i_0-1)$ and less than or equal to $S(i_0)$;
- third means of computation (15, 17) for forming a binary word having $B(i_0-1)$ bits having a predetermined identical value, $B(i_0-1)$ being equal to the sum of n(i) for n = 1 to $i_0-1$;
- means (3, 4) for constituting a code word comprising a first section constituted by the binary word of $B(i_0-1)$ bits having a predetermined identical value; and a second section constituted by a binary word whose value is $E-S(i_0-1)$.

8. Encoding device according to Claim 7, characterized in that the first means of computation (16) comprise an arithmetic and logic circuit (9 to 13) for computing the value n(i), for an integer i increasing from 1, according to the formulae:
n(1) = a
n(i) = n(i-1) if (i-1) (modulo b) is between 1 and b-1 (modulo b) = 0;
n(i) = n(i-1)+c if (i-1) (modulo b) = 0;
a, b and c being fixed positive integer constants.

9. Encoding device for the implementation of the method according to Claim 2, characterized in that it comprises:
- a plurality of encoding devices (41 to 48) according to Claim 1, in order to encode each value to be encoded, according to a plurality of code word sets, each set being defined by the value of a set of parameters;
- a plurality of devices (61 to 68) for computing the cost of encoding a block of values to be encoded for each set of code words respectively;
- means (70) for determining which set of code words provides the minimum encoding cost for a given block of values to be encoded;
- means (51 to 58) for storing the encoded values corresponding to a block of values to be encoded, for each set of code words;
- means (69, 71, 72) for reading back from the means of storing (51 to 58), the encoded values corresponding to the set of code words providing the minimum encoding cost
- means (72) for transmitting these encoded values while adding to them the value of a set of parameters defining the set of code words providing the minimum encoding cost.

10. Decoding device for the implementation of the method according to Claim 5, for decoding values having been encoded by the method according to Claim 1, characterized in that it comprises:
- means (21) for storing the bits of the series of the encoded values;
- first means of computation (29) for computing a series of integer values $n(i)$ according to a predetermined arithmetic and logic law identical to that used for the encoding, for integer values of $i$ increasing from 1;
- second means of computation (22, 26 to 28) for computing a value $2^{n(i)}-1$ for each value $n(i)$; reading, from the means of storing (21), a field constituted from $n(i)$ consecutive bits of the encoded values, separate for each value of the series $n(i)$; determining a value $i_0$ of $i$ such that $CH(i_0)$ is strictly greater than $2^{n(i0-1)}-1$ and less than or equal to $2^{n(i0)}-1$;
- third means of computation (23, 24) for adding the values $CH(i)$ for $i$ increasing from 1 to $i_0$, the value of this sum corresponding to the rank of the value to be decoded, in the set of possible decoded values, arranged in order of decreasing probability.

11. Decoding device according to Claim 10, for the implementation of the method according to Claim 6, characterized in that the first means of computation (29) comprise an arithmetic and logic circuit (31 to 34), for computing a value $n(i)$, for integer $i$ increasing from 1, according to the formulae:

$n(1) = a$

$n(i) = n(i-1)$ if $(i-1)$ (modulo b) is between 1 and b-1 = 0;

$n(i) = n(i-1)+c$ if $(i-1)$ (modulo b) = 0; a, b and c being fixed positive integer constants.

12. Decoding device according to Claim 10, for decoding values encoded by the method according to Claim 2, characterized in that the first means of computation (29) compute a series of values $N(i)$ as a function of the value of a set of parameters, which is variable for each block of values to be encoded, the value of the set of parameters being transmitted with the encoded values.

(a =1, b=1, c =1)
FIG.1

(a =1, b=2, c =1)
FIG.2

(a=1,b=1,c=2)

FIG.3

EP 0 329 533 B1

## a=1, b=1, c=1

| | | | | | | | | | | | | | | | | | | | | |
|---|---|---|---|---|---|---|---|---|---|---|---|---|---|---|---|---|---|---|---|---|
| 1 | 1 | 1 | 1 | 0 | 0 | 1 | 1 | 1 | 0 | 1 | 1 | 0 | 1 | 0 | 0 | 1 | ... |

Champ n° i

n°1  2   3   4   5

n(i)   1   2   3   4   5

CH(i)  1   3   4

## FIG.4

## a=1, b=2, c=1

| | | | | | | | | | | | | | | | | | | | |
|---|---|---|---|---|---|---|---|---|---|---|---|---|---|---|---|---|---|---|---|
| 1 | 1 | 1 | 1 | 0 | 0 | 1 | 1 | 1 | 0 | 1 | 1 | 0 | 1 | 0 | 0 | 1 | ... |

Champ n° i

n°1  2   3   4   5   6   7

n(i)  1   1   2   2   3   3   4

CH(i)  1   1   3   0

## FIG.5

## a=1, b=1, c=2

| | | | | | | | | | | | | | | | | | | | |
|---|---|---|---|---|---|---|---|---|---|---|---|---|---|---|---|---|---|---|---|
| 1 | 1 | 1 | 1 | 0 | 0 | 1 | 1 | 1 | 0 | 1 | 1 | 0 | 1 | 0 | 0 | 1 | ... |

Champ n° i

n°1   2       3           4

n(i)   1   3       4           6

CH(i)  1   7       7

## FIG.6

## FIG.7

FIG.8

FIG.9

EP 0 329 533 B1

FIG.10

DÉTECTION DES SÉPARAT. INTER-BLOCS 20

MÉMOIRE FIFO 21

REGISTRE A DÉCALAGE 22

CH(i)

ADDITIONNEUR 23

REGISTRE 24

E

30

19

DÉCALEUR A BARILLET 26

$2^{n(i)}-1$

COMPARATEUR 27

SÉQUENCEUR 28

MÉMOIRE DE PARAMÈTRES 25

a

n(i+1)

31

ADDITIONNEUR 35

REGISTRE 34

32

c

o

29

b

24

EP 0 329 533 B1